(19) Europäisches Patentamt / European Patent Office / Office européen des brevets

(11) **EP 4 331 152 B1**

(12) **FASCICULE DE BREVET EUROPEEN**

(45) Date de publication et mention de la délivrance du brevet:
**02.07.2025 Bulletin 2025/27**

(21) Numéro de dépôt: **22735500.5**

(22) Date de dépôt: **21.04.2022**

(51) Classification Internationale des Brevets (IPC):
**H04L 1/00** *(2006.01)*

(52) Classification Coopérative des Brevets (CPC):
**H04L 1/0041; H04L 1/0058;** H03M 13/1102;
H03M 13/23; H04L 1/0069

(86) Numéro de dépôt international:
**PCT/FR2022/050748**

(87) Numéro de publication internationale:
**WO 2022/229544 (03.11.2022 Gazette 2022/44)**

(54) **EMETTEUR DE DONNEES AVEC POINÇONNEUR VARIABLE**

DATENSENDER MIT VARIABLER PUNKTIONSVORRICHTUNG

DATA TRANSMITTER WITH VARIABLE PUNCTURER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.04.2021 FR 2104364**

(43) Date de publication de la demande:
**06.03.2024 Bulletin 2024/10**

(73) Titulaire: **Orange**
**92130 Issy-les-Moulineaux (FR)**

(72) Inventeurs:
• **SIAUD, Isabelle**
**92326 Châtillon Cedex (FR)**
• **ULMER-MOLL, Anne-Marie**
**92326 Châtillon Cedex (FR)**

(56) Documents cités:
**US-A1- 2003 145 273    US-A1- 2005 172 202**
**US-A1- 2008 010 582    US-A1- 2017 244 588**

**Description**

**Domaine de l'invention**

La présente invention se rapporte au domaine des télécommunications. Au sein de ce domaine, l'invention se rapporte plus particulièrement aux procédés d'émission de données d'un premier équipement de télécommunication vers un deuxième équipement avec un poinçonnage des données après codage et avant transmission par l'antenne. Elle s'applique notamment aux dispositifs portables de télécommunication qui établissent une communication via une station de base ou un point d'accès.

**Art antérieur**

Un réseau d'accès radio est constitué généralement de plusieurs stations de base ou points d'accès qui permettent à un équipement utilisateur (UE: User Equipment selon la terminologie anglo-saxonne) dit aussi ultérieurement terminal ou UE, d'avoir accès à un réseau de télécommunication et d'établir une communication pour échanger des données.

Le support de transmission des communications est couramment appelé canal de transmission ou de propagation, à l'origine en référence à un canal aérien et par extension en référence à tout canal. Les systèmes sans fil ont une interface dite de transmission RF lorsqu'il s'agit d'un système de télécommunication avec une transmission aérienne d'un signal appartenant à une bande radio (par exemple, de type 5G NR, 4G, GSM, UMTS, IEEE 802.11x, IEEE 802.16e, etc). Parmi ces systèmes, on distingue les systèmes d'accès cellulaires dits encore mobiles spécifiés plus particulièrement par le 3GPP et des systèmes à l'origine non mobiles qui comprennent ceux basés sur une norme WiFi spécifiée par l'IEEE.

Les données transmises peuvent subir des perturbations dues à des interférences introduites par le canal de transmission et/ou dues à des sources de bruit.

Pour lutter contre les perturbations, il est connu de protéger les données transmises avec un certain niveau de protection. Ainsi, une technique largement connue et utilisée consiste à ajouter de la redondance aux données au moyen d'un codeur dit parfois codeur de canal.

Toutefois, l'ajout de redondance va à l'encontre du débit utile pouvant être transmis entre deux équipements. En outre, le rendement de codage du codeur canal peut devoir répondre à certaines contraintes, par exemple être fixé dans un standard de télécommunication édité par un groupement, par exemple le 3GPP, l'IEEE. Dans certains cas, un poinçonnage doit être mis en œuvre après le codage pour adapter le rendement.

Les demandes de brevet US 2017/244588 A1, US 2008/010582 A1, US 2005/172202 A1 et US 2003/145273 A1 exposent de l'arrière-plan technologique au sujet du poinçonnage de bits au sein du codage.

**Exposé de l'invention**

L'invention propose un procédé de communication ayant pour objectif d'améliorer la protection des données transmises.

L'invention a pour objet un procédé d'émission de données mis en œuvre par un premier équipement de télécommunication à destination d'un deuxième équipement de télécommunication.

Le procédé est tel qu'il comprend :

- codage de données d'entrée pour ajouter une redondance au moyen d'un codeur,
- poinçonnage des données après codage,
- émission des données après poinçonnage,

et est tel que le poinçonnage est selon au moins deux niveaux de protection différents et est tel qu'il comprend au moins une étape de poinçonnage comprenant une $1^{ère}$ matrice de poinçonnage dont la sortie alimente un démultiplexage ayant une $1^{ère}$ et une $2^e$ sorties, la $2^e$ sortie alimentant une $2^{nde}$ matrice de poinçonnage pour définir les au moins deux niveaux de protection différents obtenus respectivement avec la $1^{ère}$ sortie du démultiplexage et la sortie de la $2^{nde}$ matrice de poinçonnage.

L'invention a en outre pour objet un équipement de télécommunication destiné à communiquer avec un deuxième équipement. L'équipement comprend :

- un codeur pour coder des données d'entrée,
- un poinçonneur pour poinçonner les données selon au moins deux niveaux de protection après codage, le poinçonneur comprenant :

une structure élémentaire comprenant une 1ère matrice de poinçonnage dont la sortie alimente un démultiplexeur ayant une 1ère et une 2e sorties, la 2e sortie alimentant une 2nde matrice de poinçonnage pour définir les au moins deux niveaux de protection différents obtenus respectivement avec la 1ère sortie du démultiplexeur et la sortie de la 2nde matrice de poinçonnage.

Les données d'entrée sont codées par un même codeur pour ajouter de la redondance et générer un train de bits non différenciés.

Le poinçonnage des données selon l'invention est réalisé, après codage, en mettant en œuvre au moins deux matrices de poinçonnage séparées par un démultiplexage. Le démultiplexage permet de répartir les données en sortie i.e. associées à des niveaux de protection différents pour obtenir un débit binaire déterminé sur chacune de ces sorties. Un tel procédé permet aisément de déterminer deux rendements de codage différents associés aux deux sorties. Ce procédé est beaucoup moins complexe que des techniques connues avec plusieurs codages en parallèle pour délivrer des débits importants.

Selon un mode de réalisation, le procédé d'émission de données est tel que toute étape de poinçonnage dite étape précédente est suivie d'une nouvelle étape de poinçonnage dont la 1ère matrice est commune avec la 2nde matrice de l'étape précédente, pour définir un niveau de protection différent supplémentaire obtenu avec la sortie de la 2nde matrice de poinçonnage de la nouvelle étape de poinçonnage.

Selon un mode de réalisation, le poinçonneur est tel que toute structure élémentaire dite structure précédente est suivie d'une nouvelle structure élémentaire dont la 1ère matrice est commune avec la 2nde matrice de la structure élémentaire précédente, pour définir un niveau de protection différent supplémentaire obtenu avec la sortie de la 2nde matrice de poinçonnage de la nouvelle structure élémentaire.

Selon ces modes précédents de réalisation du procédé et de l'équipement, chaque ajout d'une étape de poinçonnage/d'une structure élémentaire permet d'obtenir un nouveau rendement de codage différent des précédents et associé au nouveau niveau de protection. Ce mode permet ainsi d'accroître l'ordre de poinçonnage avec beaucoup de simplicité.

Selon un mode de réalisation, un ratio de poinçonnage est associé à chaque matrice de poinçonnage et les ratios sont déterminés pour un débit binaire identique sur chacune des sorties des 2nde matrices de poinçonnage des étapes de poinçonnage/des structures élémentaires, pour un ordre de la modulation et pour un rendement du codage déterminés.

Selon un mode de réalisation, un ratio de poinçonnage est associé à chaque matrice de poinçonnage et un changement de niveau de protection des données est obtenu en modifiant le ratio d'au moins une des matrices de poinçonnage.

Selon un mode de réalisation, le procédé d'émission de données comprend en outre :

- mappage des données après poinçonnage sur un symbole parmi M symboles d'une constellation d'ordre q, M=$2^q$ q>=2, chaque symbole de la constellation comprenant au moins deux bits de poids différents parmi q bits et

le procédé est tel que, pour au moins un des M symboles, les deux niveaux de protection différents correspondent à un poinçonnage différent des données en fonction du poids des bits dans le symbole sur lesquels sont mappées ces données et
tel que l'émission des données à destination du deuxième équipement intervient après mappage. Selon un mode de réalisation, l'équipement de télécommunication comprend en outre :

- un modulateur pour mapper les données après poinçonnage sur un symbole parmi M symboles d'une constellation d'ordre M, M=$2^q$ q>=2, chaque symbole de la constellation comprenant au moins deux bits de poids différents,

le poinçonneur étant tel que le poinçonnage des données est différent en fonction du poids des bits dans un symbole sur lesquels sont mappées les données.

Selon ces modes précédents de réalisation du procédé et de l'équipement, le poinçonnage après codage distingue entre les données codées selon sur quels bits d'un symbole de la constellation elles sont mappées. Selon une représentation de la constellation selon deux axes perpendiculaires qui définissent quatre quadrants, le bit de poids fort d'un ensemble de bits mappés sur un symbole est par convention celui qui est situé à gauche de l'ensemble. Cependant, une modulation $x^2$QAM peut être construite en combinant deux modulations d'amplitude d'ordre x en phase et quadrature, l'une portée par l'axe I et l'autre par l'axe Q dans la représentation bande de base d'une modulation numérique. Dans ces cas, il y a un bit de poids fort pour chaque ensemble de bits mappés sur un symbole pour chaque modulation x-AM même si les deux ensembles forment un code binaire mappé globalement sur un même symbole de la modulation $x^2$QAM. Le poinçonnage appliqué aux données après codage est tel qu'il permet de distinguer au moins deux niveaux de protection différents associés respectivement aux données mappées sur des bits de poids différents d'un symbole de la constellation. Ainsi, contrairement aux techniques classiques, les différents niveaux permettent d'obtenir une protection non uniforme (UEP UnEqual Protection) au sein d'un même symbole de la constellation, c'est-à-dire que la protection est différente entre certains bits d'un même symbole de la constellation.

L'invention permet en particulier d'attribuer une meilleure protection aux données mappées sur des bits de poids faible comparativement à des bits de poids supérieur qu'ils soient de poids intermédiaire ou de poids fort.

Ainsi, en exploitant le fait qu'entre des bits de poids différents ceux de poids plus forts sont plus robustes que ceux de poids plus faibles à une erreur de décision lors du décodage pour distinguer deux niveaux de protection différents entre ces bits de poids différents, le procédé permet avantageusement de maintenir un même débit binaire de transmission des données tout en garantissant une meilleure protection aux données transmises.

Selon un mode de réalisation, chaque symbole de la constellation comprend au moins un bit de poids fort et un bit de poids faible et le poinçonnage des données est différent entre des données mappées sur le bit de poids fort et des données mappées sur le bit de poids faible d'un même symbole.

Selon un mode de réalisation, la différence de poinçonnage entre des données mappées sur un même symbole intervient pour tous les symboles de la constellation.

Selon un mode de réalisation, la différence de poinçonnage entre des données mappées sur un même symbole intervient uniquement pour certains des symboles de la constellation,

Selon un mode de réalisation, le poinçonnage des données est en outre fonction de la position du symbole dans la constellation sur lequel sont mappées ces données après poinçonnage.

Selon ce mode, la protection variable tient compte en outre de la position du symbole dans la constellation. En présence de bruit de phase, les symboles transmis subissent une rotation de phase.

Et une erreur de phase qui dépasse un seuil $\delta\theta$ induit un changement de région de décision pour les symboles en périphérie de la constellation lors du décodage de ces symboles à la réception. Ainsi, le procédé permet en particulier d'augmenter la protection des symboles complexes en périphérie de la constellation et par conséquent de lutter spécifiquement contre des sources de bruit particulières telles que de type bruit de phase qui affectent plus particulièrement ces symboles en périphérie.

L'invention permet ainsi de limiter les interférences dues à ces sources de bruit.

Selon un mode de réalisation, la position du symbole est évaluée par le calcul d'une métrique d'évaluation de la distance du symbole au centre de la constellation.

Selon ce mode, le calcul de la distance du symbole au centre de la constellation donne les positions possibles du symbole sur un cercle de rayon égal à la distance calculée. Les symboles pour lesquels la distance calculée est la plus grande correspondent à des symboles de périphérie. Ces symboles sont ceux les plus sensibles à une rotation de phase.

L'invention a en outre pour objet un procédé de communication entre un premier équipement et un deuxième équipement de télécommunication avec réception d'un signal de données par le deuxième équipement, les données étant mappées avant émission sur des symboles d'une constellation d'ordre M, $M=2^q$ $q>=2$, chaque symbole de la constellation comprenant au moins deux bits de poids différents. Le procédé de communication est tel qu'il comprend :

- démodulation des symboles avec démappage des données,
- dé-poinçonnage des données après démappage des données, le poinçonnage des données à l'émission étant différent en fonction du poids des bits dans un symbole sur lesquels sont mappées les données,
- décodage des données après dé-poinçonnage.

Selon un mode de réalisation, le dé-poinçonnage des données tient compte d'un poinçonnage à l'émission fonction de la position du symbole dans la constellation sur lequel sont mappées ces données.

L'invention a en outre pour objet un équipement de télécommunication destiné à communiquer avec un premier équipement pour recevoir un signal de données, les données étant mappées avant émission sur des symboles d'une constellation d'ordre M, $M=2^q$ $q>=2$, chaque symbole de la constellation comprenant au moins deux bits de poids différents. L'équipement est tel qu'il comprend :

- un démodulateur pour démoduler des symboles avec démappage des données,
- un dé-poinçonneur pour dé-poinçonner les données après démappage des données, le poinçonnage des données à l'émission étant différent en fonction du poids des bits dans un symbole sur lesquels sont mappées les données,
- un décodeur pour décoder les données après dé-poinçonnage.

L'invention a en outre pour objet un programme d'ordinateur sur un support d'informations, ledit programme comportant des instructions de programme adaptées à la mise en œuvre d'un procédé selon l'invention lorsque ledit programme est chargé et exécuté dans un équipement de télécommunication.

L'invention a en outre pour objet un support d'informations comportant des instructions de programme adaptées à la mise en œuvre d'un procédé selon l'invention, lorsque ledit programme est chargé et exécuté dans un équipement de télécommunication.

L'invention a en outre pour objet un signal numérique comprenant des données émis par un premier équipement à destination un deuxième équipement, les données transmises étant mappées sur des symboles d'une constellation, chaque symbole de la constellation comprenant au moins deux bits de poids différents, les données ayant été poinçonnées différemment avant mappage en fonction du poids des bits dans un symbole sur lesquels sont mappées ces données.

## Liste des figures

D'autres caractéristiques et avantages de l'invention apparaîtront plus clairement à la lecture de la description suivante de modes de réalisation, donnés à titre de simples exemples illustratifs et non limitatifs, et des dessins annexés, parmi lesquels :

[Fig 1] La figure 1 est un schéma d'un mode de réalisation d'une chaîne d'émission selon l'invention,
[Fig 2] La figure 2 donne un codage binaire pur et un codage de Gray réalisées sur k=4, k=3 et k=2 bits,
[Fig 3] La figure 3 est une représentation d'une modulation MAQ-16 dans un repère (I,Q) qui respecte un codage de Gray avec illustration de régions de décision,
[Fig 4] La figure 4 est un schéma d'un mode de réalisation d'une chaîne de réception selon l'invention,
[Fig 5] La figure 5 est une représentation d'une modulation MAQ-64 dans un repère (I,Q) qui respecte un codage de Gray avec illustration de régions de décision,
[Fig 6] La figure 6 est une représentation d'une modulation MAQ-16 dans un repère (I,Q) qui respecte un codage de Gray avec identification des positions les plus éloignées du centre et indication d'un angle θ,
[Fig 7] La figure 7 est une représentation d'une modulation MAQ-16 dans un repère (I,Q) avec illustration de régions de décision et avec indication de l'impact d'une rotation d'un angle θ sur la position de certains symboles,
[Fig 8] La figure 8 est un schéma d'un mode de réalisation de la structure élémentaire du poinçonneur selon l'invention connectée en sortie du codeur pour obtenir deux niveaux de protection,
[Fig 9] La figure 9 est un schéma d'un mode de réalisation d'un montage en cascade de la structure élémentaire du poinçonneur selon l'invention pour obtenir trois niveaux de protection,
[Fig 10] La figure 10 est un schéma d'un mode de réalisation de la structure élémentaire du poinçonneur selon l'invention connectée en sortie du codeur avec un schéma d'une représentation équivalente de cette structure avec le codeur,
[Fig 11] La figure 11 est une représentation d'une modulation 64 QAM avec la distinction de trois zones Z1, Z2, Z3 de symboles en fonction de leur distance au centre de la constellation.

## Description de modes de réalisation particuliers

Le principe général de l'invention repose sur un poinçonnage des données à transmettre avec l'application aux données d'au moins deux matrices de poinçonnage successives séparées par un démultiplexage qui permet de distinguer au moins deux niveaux de protection différents pour ces données. Le poinçonneur qui met en œuvre ce poinçonnage comprend une structure élémentaire de base comprenant la 1$^{\text{ère}}$ matrice de poinçonnage suivie d'un démultiplexeur a deux sorties lui-même suivi sur sa 2$^{\text{e}}$ sortie de la 2$^{\text{e}}$ matrice de poinçonnage. Les au moins deux niveaux de protection différents sont obtenus respectivement avec la 1$^{\text{ère}}$ sortie du démultiplexeur et la sortie de la 2$^{\text{nde}}$ matrice de poinçonnage. La structure de poinçonnage multi-niveaux proposée permet une réduction de complexité d'une structure de codage canal multi niveaux à l'émission tout en permettant en aval un codage binaire à signal.

Les deux niveaux de protection différents peuvent être associés respectivement aux données mappées sur des bits de poids différents des symboles d'une constellation associée à une modulation numérique. Dit autrement, au sein d'un même symbole de la constellation, selon qu'une donnée est mappée sur un bit de poids fort ou sur un bit de poids faible alors elle ne bénéficie pas du même rapport de poinçonnage. La différence de niveau de protection entre des données mappées sur un même symbole peut être mise en œuvre selon l'invention pour tous les symboles ou pour uniquement un symbole ou certains symboles de la constellation.

En alternative ou en outre, deux niveaux de protection différents peuvent être associés respectivement aux données mappées sur des symboles d'une constellation localisés à des positions différentes. Dit autrement, selon qu'une donnée est mappée sur un symbole positionné à un certain point de la constellation ou sur un symbole positionné à un autre point de la constellation alors elle ne bénéficie pas du même rapport de poinçonnage. La différence de niveau de protection entre des données mappées sur des symboles différents de la constellation peut être mise en œuvre selon l'invention pour tous les symboles ou pour uniquement certains symboles d'une même constellation associée à une modulation numérique.

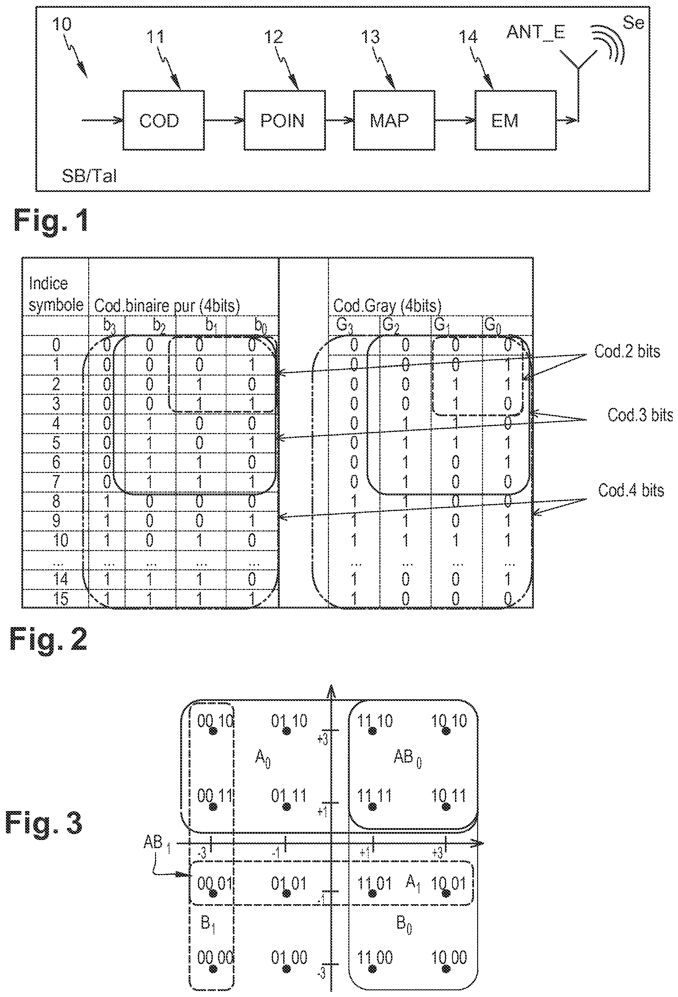

La figure 1 est un schéma d'un mode de réalisation d'une chaîne d'émission pour la mise en œuvre d'un procédé selon l'invention. Cette chaîne d'émission fait partie d'un dispositif de télécommunication qui peut tout aussi bien être une station de base SB qu'un terminal Tal tel un smartphone. La chaîne comprend a minima un codeur COD canal, un poinçonneur POIN et un modulateur MAP.

Le procédé 10 d'émission de données est mis en œuvre par le dispositif SB/Tal. Le procédé comprend au moins le codage 11 des données d'entrée, le poinçonnage 12 des données après codage, la modulation 13 avec mappage des données après poinçonnage sur un symbole parmi M symboles d'une constellation d'ordre M, $= 2^q, q \geq 2$, chaque symbole de la constellation comprenant au moins deux bits de poids différents. M, q des entiers.

Le procédé est tel que, pour au moins un des M symboles, le poinçonnage des données est différent en fonction du poids des bits dans le symbole sur lequel sont mappées ces données.

L'émission 14 des données après mappage est à destination d'un autre équipement de télécommunication qui peut tout aussi bien être un terminal qu'une station de base.

Le codeur canal COD effectue le codage 11 des données binaires d'entrée provenant d'une source d'information qui peut tout aussi bien être un microphone d'un terminal mobile qu'une application locale ou distante telle qu'une application de messages courts (SMS), une application de transmission de contenu multimédia. Le codeur introduit une redondance binaire aux données d'entrée avec un rendement de codage Ri pour sortir des données binaires avec un certain débit. Le poinçonneur POIN effectue le poinçonnage 12 des données après codage canal. Le poinçonnage des données après codage est réalisé en mettant en œuvre plusieurs matrices de poinçonnage avec un démultiplexeur entre deux matrices. Le poinçonnage permet d'accroitre le débit utile de l'information pour un débit binaire fixé.

Le modulateur MAP module 13 les données après poinçonnage pour générer en sortie des symboles modulés complexes associés à une modulation.

L'émetteur EM émet les données après modulation via une antenne d'émission ANT_E sous la forme d'un signal *Se*. Le signal transmis par l'antenne ANT_E est généralement issu de la modulation d'une porteuse dite RF (Radio Frequence) par le signal modulant qui porte les données. D'autres traitements peuvent bien entendu intervenir dans la chaîne avant ou après chacun des traitements illustrés par la figure 1.

Les données codées sont arrangées en bloc de données binaires et la modulation par le modulateur MAP mappe ces données binaires sur les symboles d'une constellation pour construire le signal qui intervient dans la modulation de la porteuse RF. Le mapping des données peut respecter un codage dit de Gray.

Ainsi, le signal modulant de la porteuse RF décrit en bande de base porte l'information à transmettre et est représenté sous la forme de symboles complexes répartis dans le plan (I,Q) sur lesquels ont été mappées les données.

Chaque symbole de la constellation comprend au moins un bit de poids fort et un bit de poids faible. Le modulateur MAP mappe les données sur un symbole parmi M symboles d'une constellation d'ordre M, $M \geq 4$ en respectant la contrainte que des données mappées sur le bit de poids fort et des données mappées sur le bit de poids faible d'un même symbole ont été différemment poinçonnées. Le mappage recouvre ainsi une opération dite de codage binaire à symbole qui peut être décrite comme une transformation d'un ensemble binaire $\{b_{k-1}, b_{k-2}, ..., b_0\}$ en un symbole $S_c$ de la constellation. La transformation permet de construire des symboles de type M-aire avec une représentation binaire de k=log2(M) bits, $\{b_{k-1}, b_{k-2}, ..., b_0\}$, correspondant à un mot binaire avec $M = 2^k$. Selon une mise en œuvre, les symboles M-aire de la constellation prennent leur valeur dans l'espace des entiers relatifs Z constitués de M éléments pris dans l'alphabet A=$\{\pm 1, \pm 3, ... \pm (2p+1), ..., \pm (M-1)\}$, selon un codage NRZ qui a l'avantage d'être plus favorable pour une transmission. k un entier.

La transformation respecte généralement un codage de Gray et une combinaison spécifique de bits est assigné à chaque entier relatif de l'alphabet A. Un codage de Gray se déduit d'un codage binaire dit pur. Un codage binaire pur repose sur les opérations d'addition et de multiplication dans le corps de Galois formé des entiers {0,1} où l'addition correspond à l'opération logique 'OU Exclusif' et la multiplication à l'opération 'ET' logique. L'incrément dans l'alphabet M-aire d'un nombre relatif (2p+1) à 2(p+1)+1 est réalisé en ajoutant (addition OU exclusif ($\oplus$)) un bit de poids faible égal à 1 sur le mot de code binaire courant pour générer le nouveau mot de code binaire associé au symbole 2(p+1)+1. p un entier.

Le bit de poids fort (MSB ou Most Significant Bit $b_{k-1}$) est le bit, dans une représentation binaire donnée, ayant le plus grand poids ou la plus grande position (celle de gauche dans la notation positionnelle habituelle), c'est le bit le plus robuste aux transitions d'états d'un symbole à un autre. Le bit de poids faible (LSB ou Least Significant Bit) est le bit, dans une représentation binaire donnée, ayant le plus petit poids ou la plus petite position (celle de droite dans la notation positionnelle habituelle). Il correspond à l'unité élémentaire de variation (d'état) d'un symbole. Cette notion de poids de bit dans un symbole se rapporte au mode de construction d'un codage binaire pur où la robustesse aux transitions d'état augmente avec le poids du bit dans chaque mot de code, c'est-à-dire avec sa position dans le mot de code.

Le codage de Gray est un codage spécifique dérivé du codage binaire pur qui ne modifie que d'un bit deux mots de code binaire successifs (un mot de code est la représentation binaire du symbole M-aire). Ce code de Gray minimise les erreurs de transition d'un mot de code à l'autre lorsque l'indice d'état (indice du symbole M-aire) est incrémenté de 1. Le passage du codage binaire pur au codage de Gray se fait en effectuant une opération OU Exclusif ($\oplus$) sur les bits d'un mot de code binaire pur.

En désignant par $b_n$ ($b_0$ = LSB, bit de poids faible) un bit quelconque en code binaire pur et par $G_n$ le bit recherché

en code Gray en position n, pour un mot de code donné, le bit $G_n$ suivant un codage de Gray, est obtenu comme suit :

$$G_n = b_n \oplus b_{n+1} \; ; \; G_{MSB} = b_{MSB} \tag{1}$$

où $b_n$ et $b_{n+1}$ sont deux bits dans le même mot de code d'un codage binaire pur aux positions n et n+1 et respectivement de poids n et n+1. Le bit de poids fort est le bit le plus à gauche dans la représentation d'un codage binaire pur.

A la réception, le décodage de Gray pour régénérer un code binaire pur s'effectue en réalisant l'opération suivante :

$$b_n = G_n \oplus b_{n+1} \tag{2}$$

Le poids des bits dans un symbole est hiérarchisé suivant sa robustesse à une erreur de décodage binaire à symbole.

Les [Table 1] et [Table 2] en Annexe donnent une illustration d'un codage binaire pur et d'un codage de Gray pour respectivement M=16 (et k=4) et M=8 (et k=3). Les bits de poids forts restent inchangés en codage binaire pur et en codage de Gray pour les indices des symboles variant de 0 à 7 et de 8 à 15 ce qui leur confère une plus grande robustesse lors d'une transition d'un état à un autre.

Les opérations de codage binaire pur et de codage de Gray réalisées sur k=4, k=3 et k=2 bits peuvent se déduire les unes des autres de par leur mode de construction car les poids des bits sont décroissants de la gauche vers la droite comme illustré par la figure 2. En d'autres termes, la hiérarchisation et l'imbrication du codage suivant le nombre de bits par symbole apparait de façon explicite dans la construction des mots de code suivant le poids du bit et sa position dans le mot de code.

Une modulation dite MAQ-M=$2^{2k}$=$N^2$ peut être construite en combinant deux modulations d'amplitude d'ordre N=$2^k$ en phase et en quadrature l'une portée par l'axe I et l'autre par l'axe Q dans la représentation en bande de base d'une modulation. Pour chacune des deux modulations les abscisse $S_{n,i}$ et ordonnée $S_{n,q}$ de chaque symbole $S_n$ prennent leur valeurs dans l'alphabet A={$\pm 1$, $\pm 3$, ...$\pm$ (2p+1), ...,$\pm$ (N-1)}.

$$S_n = S_{n,i} + j\, S_{n,q} \tag{3}$$

La combinaison des deux modulations génère la modulation MAQ à M états à laquelle correspond une constellation à M symboles $S_m$. Les symboles complexes du signal modulant la porteuse RF sont chacun formés de 2xlog2(N) bits ($b_{2k-1}$, $b_{2k-2}$,... $b_k$, $b_{k-1}$,..., $b_0$) où {$b_{2k-1}$, $b_{2k-2}$,... $b_k$} décrit le codage binaire de la modulation d'amplitude en phase et {$b_{k-1}$, $b_{k-2}$,..., $b_0$} décrit le codage binaire de la modulation d'amplitude en quadrature comme donné dans la [Table 3] en Annexe. Les symboles sont repartis dans le plan I, Q de telle sorte que les symboles adjacents ne diffèrent que d'un bit en conformité avec le codage de Gray suivant une position déterminée par rapport au symbole d'indice 0 comme illustré par la figure 3 pour une modulation MAQ-16. Selon cette construction, les voies I et Q sont modulées et démodulées de façon indépendante.

Notion de régions de décision à la réception

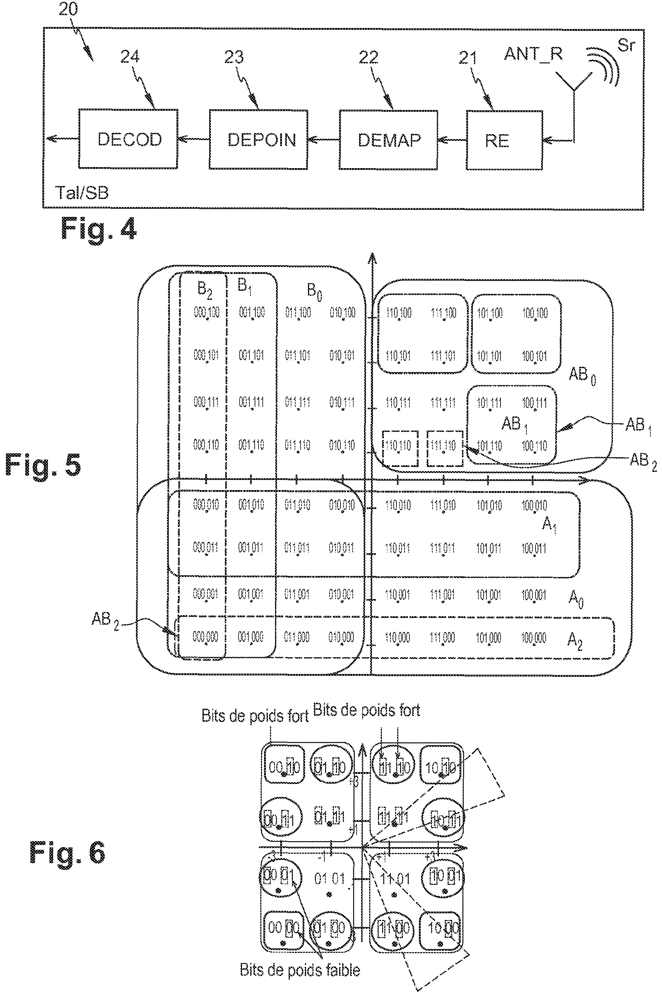

La figure 4 est un schéma d'un mode de réalisation d'une chaîne de réception pour la mise en œuvre d'un procédé de communication selon l'invention. Cette chaîne de réception fait partie d'un dispositif de télécommunication qui peut tout aussi bien être un terminal Tal tel un smartphone qu'une station de base SB. Cette chaîne effectue a minima les fonctions inverses de celles à l'émission illustrées par la figure 1. Cette chaîne de réception comprend a minima un démodulateur DEMAP, un dépoinçonneur DEPOIN et un décodeur DECOD.

Le signal de données Sr reçu 21 par un récepteur RE via l'antenne de réception ANT_R correspond au signal Se émis par l'antenne d'émission ANT_E après transmission par le canal de propagation : les données portées par le signal émis ayant étant mappées avant émission sur des symboles d'une constellation d'ordre M, M=$2^q$ q>=2, chaque symbole de la constellation comprenant au moins deux bits de poids différents, et le poinçonnage des données avant mappage étant différent en fonction du poids des bits dans le symbole sur lesquels sont mappées les données.

Le procédé 20 de communication comprend au moins la démodulation 22 des symboles avec démappage des données, le dé-poinçonnage 23 des données après démappage des données, le décodage 24 des données après dé-poinçonnage par le dispositif Tal/SB.

Le démodulateur DEMAP effectue une fonction de demapping 22 inverse de celle mise en œuvre par le modulateur MAP.

Le dépoinçonneur DEPOIN effectue une fonction de dépoinçonnage 23 inverse de celle mise en œuvre par le poinçonneur POIN dans le sens où il permet de restituer les bits poinçonnés.

Le décodeur DECOD effectue une fonction de décodage 24 inverse de la fonction de codage mise en œuvre par le codeur COD.

La démodulation 22 mise en œuvre par le démodulateur DEMAP vise à déterminer à partir d'un point reçu le symbole émis le plus probable. Les points reçus sont entachés de bruit thermique mais aussi de bruits d'origines diverses tel que du bruit de phase, qui engendrent une variation de la position des symboles complexes dans la constellation par rotation de phase. Lors de cette opération de démodulation 22, le procédé effectue par exemple une détection à maximum de vraisemblance. Selon ce mode de mise en œuvre, le procédé détermine le symbole le plus proche de l'observation (symbole reçu) selon un critère de distance Euclidienne entre les symboles de la constellation et le symbole reçu.

La prise de décision sur le symbole le plus proche peut être illustrée avec la notion de régions de décision. De telles régions de décision sont schématisées sur la figure 3 dans le cas d'une répartition des symboles dans la constellation qui respecte le codage de Gray (deux symboles adjacents ne diffèrent que d'un bit). La région de décision associée à un symbole complexe dans son ensemble est l'intersection des régions de décision attachées à chaque bit formant le symbole sachant que ce symbole est positionné dans la constellation suivant son indice spécifié lors de l'opération de codage binaire.

Selon l'illustration de la figure 3, le rectangle A0 représente la région de décision associée aux bits de poids fort pour la modulation d'amplitude MA-4 en quadrature i.e. selon l'axe Q. C'est -à-dire que dans cette région le bit de poids fort de chacun des symboles de cette modulation est à un alors que tous les symboles en dehors de cette région ont leur bit de poids fort à zéro. Le rectangle B0 représente la région de décision associée aux bits de poids fort pour la modulation d'amplitude MA-4 en phase i.e. selon l'axe I. L'intersection des deux rectangles A0 et B0, c'est-à-dire la région (AB0), fournit la région de décision pour les bits de poids forts de la modulation MAQ-16 dont chaque symbole a deux bits de poids forts relatifs à chacune des modulations MA-4. Cette région de décision AB0 est celle où les deux bits de poids fort d'un symbole MAQ-16 sont à un selon cette construction avec deux modulations MA-4.

Le rectangle A1 représente la région de décision associée au bit de poids faible pour la modulation d'amplitude MA-4 selon l'axe Q.

Le rectangle B1 représente la région de décision associée au bit de poids faible pour la modulation d'amplitude MA-4 selon l'axe I.

L'intersection des deux rectangles A1 et B1, c'est-à-dire la région AB1, fournit la région de décision pour les bits de poids faibles de la modulation MAQ-16 selon cette construction avec deux modulations MA-4.

Lors de la démodulation numérique, le symbole estimé répond au critère de maximum de vraisemblance tel que les régions de décision considérées pour chaque symbole correspondent à l'intersection des régions de décision des bits formant le symbole. Ces intersections correspondent à celles des bits de poids faible.

La démodulation 22 selon l'invention qui effectue un décodage binaire à symbole permet de pondérer l'erreur d'estimation des bits transmis associée à la variation des régions de décision suivant le poids et éventuellement la position du bit dans la constellation.

La [Table 4] en Annexe et la figure 5 sont relatives à une MAQ-64. Selon la construction illustrée, la modulation 64-QAM est générée en combinant en phase et quadrature deux modulations d'amplitude à huit états MA-8 portées respectivement par les voies I et Q. Chaque modulation d'amplitude MA-8 est caractérisée par trois bits de poids (ou niveaux) différents associés à leurs positions lors du codage binaire. Il en résulte trois types de zones différentes pour la délimitation des régions de décision des bits émis lors de l'opération de décodage binaire à symbole.

Chaque symbole MAQ-64 est formé de 6 bits $\{b_{k-1}, b_{k-2},..., b_0\}$ avec k=6. Les trois premiers bits décrivent la modulation d'amplitude MA-8 en phase et les trois derniers bits décrivent la modulation d'amplitude MA-8 en quadrature.

Sur la figure 5 les régions de décision $AB_0$ associées aux bits de poids forts MSB de position $\{G_5,G_2\}$ résultent de l'intersection des régions de type $A_0$ et $B_0$.

Les zones carré en pointillés $AB_1$ représentent la délimitation de la région de décision pour les bits de poids intermédiaire correspondant aux bits en position $[G_4,G_1]$. Il s'agit de l'intersection des deux régions de décision $A_1$ et $B_1$ associées aux bits de poids intermédiaire pour les modulations MA-8 en phase et en quadrature.

L'intersection des régions de décision du type $A_2$ et $B_2$, c'est-à-dire la région de décision $AB_2$, fournit la région de décision pour les bits de poids faible LSB de la modulation MAQ-64. Ces régions de type $AB_2$ coïncident avec les régions de décision associées au symbole complexe $S_m$ de la modulation MAQ-64.

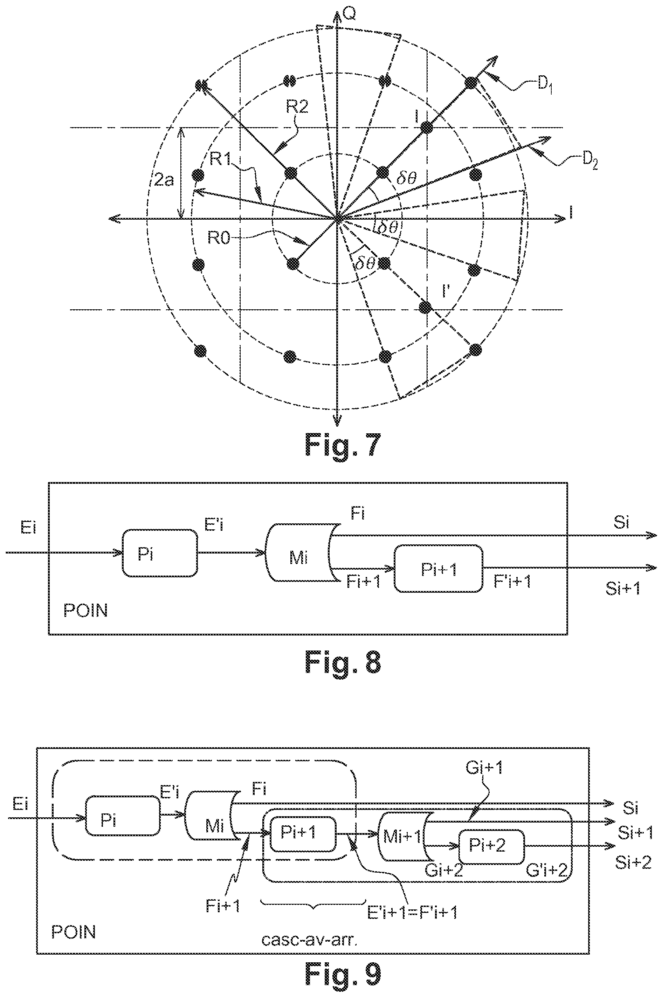

Les figures 6 et 7 représentent une MAQ-16. Les symboles de périphérie sont représentés entourés d'un carré sur la figure 6, ils sont ceux dont les abscisses et ordonnées sont les plus grandes en valeur absolue. En présence de bruit de phase, les symboles transmis subissent une rotation de phase. Une erreur de phase qui dépasse un certain seuil induit un changement de région de décision pour les symboles en périphérie de la constellation lors du décodage de ces symboles à la réception. Ce changement induit donc une erreur lors de la prise de décision sur le symbole émis qui intervient lors de la démodulation numérique.

Considérons une rotation de phase $\delta\theta$ correspondant à l'angle entre d'une part la médiane $D_1$ passant par le centre O de la constellation et reliant deux symboles de la constellation dont les distances sont égales sur les composantes en phase et quadrature de la modulation numérique et d'autre part la droite $D_2$ partant du centre O de la constellation et passant par le symbole adjacent le plus proche et correspondant à une région de décision adjacente.

Les symboles entourés d'un carré sur la figure 6 sont les symboles les plus sensibles à la rotation de phase $\delta\theta$, ils changent de région de décision après la rotation. Ces symboles se trouvent sur un cercle de rayon $R2$ :

$$R2 = 3\sqrt{2}\ a \tag{4}$$

avec 2$a$ la largeur d'une région de décision.

Une même rotation de phase $\delta\theta$ entraine une indétermination sur la région de décision pour les symboles entourés d'un rond et situés à distance intermédiaire R1 du centre O de la constellation. En effet, la rotation, avec une précision de l'ordre de 9%, positionne un de ces symboles reçus à l'intersection des droites délimitant quatre régions de décision (points I et I' sur la figure 7). Ce positionnement peut donc générer une indétermination à la réception sur le symbole émis. Le rayon R1 est donné par :

$$R1 = \sqrt{10}\ a \tag{5}$$

Cette même rotation $\delta\theta$ sur les symboles les plus proches du centre de la constellation et situés à une distance R0 du centre de la constellation ( $R0 = \sqrt{2}\ a$ ), n'engendre pas de changement de région de décision comme illustré sur la figure 7.

<u>Structure élémentaire du poinçonneur</u>

Un mode de réalisation d'un poinçonneur est représenté en figure 8.

Selon ce mode, le poinçonneur POIN comprend une structure élémentaire. La structure élémentaire délimitée par le trait interrompu a une entrée Ei et deux sorties Si et Si+1. Elle est constituée d'un premier module de poinçonnage Pi à une entrée Ei et une sortie E'i, suivi d'un démultiplexeur Mi [1:2] (une entrée E'i vers deux sorties Fi et Fi+1) dont la branche Fi+1 de sortie est reliée à un deuxième module de poinçonnage Pi+1. L'entrée du deuxième module Pi+1 de poinçonnage est Fi+1 et sa sortie est notée F'i+1. Le démultiplexeur Mi est destiné à répartir sur ses deux sorties Fi et Fi+1 les données destinées aux branches Si et Si+1 de telle sorte que les débits de sortie soient contrôlés sur chacune des branches. Chaque module de poinçonnage Pi, Pi+1 met en œuvre une matrice de poinçonnage, notée Pi, Pi+1 comme le module de poinçonnage correspondant, dont la taille dépend du rapport de poinçonnage du module.

Le poinçonneur POIN comprend alors deux sorties Si et Si+1 ayant des niveaux de protection qui peuvent être différents entre eux en fonction du paramétrage de la matrice de poinçonnage Pi+1, soit au plus deux niveaux différents de protection. Si cette matrice de poinçonnage Pi+1 contient au moins un zéro alors les deux sorties Si et Si+1 ont des niveaux de protection qui sont différents entre eux.

Selon un choix déterminé, les données sur la sortie Si qui correspond à la sortie Fi du démultiplexeur Mi sont mappées sur les bits de poids faible. Selon ce même choix, les données sur la sortie Si+1 qui correspond à la sortie F'i+1 du deuxième module de poinçonnage Pi+1 sont mappées sur les bits de poids fort. Ainsi, selon ce mode de réalisation de l'invention, les données d'entrée Ei sont poinçonnées différemment selon qu'elles sont mappées sur des bits de poids faible ou sur des bits de poids fort d'un symbole de la constellation.

La matrice Pi conduit à un poinçonnage uniforme sur les deux sorties Si et Si+1 lorsque la matrice Pi+1 est inactive i.e. n'est formée que de « un ».

Selon un mode de mise en œuvre, le poinçonneur précédent à deux sorties, donc avec au moins une structure élémentaire, peut permettre d'obtenir plus que deux niveaux de protection. En particulier, un premier paramétrage de la matrice de poinçonnage Pi+1 permet d'obtenir deux niveaux de protection sur les deux sorties Si et Si+1 et un deuxième paramétrage de la matrice de poinçonnage Pi+1 permet d'obtenir deux autres niveaux de protection sur les deux sorties Si et Si+1.

Ainsi, en modifiant uniquement le paramétrage de la matrice de poinçonnage Pi+1 il est possible d'obtenir des couples différents de niveaux de protection sur les deux sorties Si et Si+1, que la matrice Pi soit active ou pas.

Selon un mode de réalisation, le dispositif SB/Tal de télécommunication destiné à communiquer avec un deuxième dispositif Tal/SB comprend un poinçonneur POIN avec la structure élémentaire décrite ci-dessus. Le procédé 10 d'émission de données mis en œuvre par ce mode de réalisation du dispositif SB/Tal est tel que le poinçonnage 3 des données est selon au moins deux niveaux de protection différents respectivement pour des données mappées sur des bits de poids différents d'un même symbole. Et plus particulièrement, le procédé est tel que le poinçonnage 3 comprend au moins une étape de poinçonnage comprenant une 1ère matrice de poinçonnage dont la sortie alimente un démultiplexage ayant une 1ère et une 2e sorties, la 2e sortie alimentant une 2nde matrice de poinçonnage pour définir les au moins deux niveaux de protection différents obtenus respectivement avec la 1ère sortie du démultiplexage et la sortie de la 2nde matrice de poinçonnage.

Selon un autre mode de réalisation illustré par la figure 9, le poinçonneur POIN comprend une première structure élémentaire suivie d'au moins une deuxième structure élémentaire mise en cascade de manière imbriquée dite cascade avant-arrière casc-av-arr. Selon ce mode, le premier module de poinçonnage de la deuxième structure, i.e la matrice Pi+1, est commun avec le deuxième module de poinçonnage de la première structure. Le poinçonneur POIN comprend alors trois sorties Si, Si+1, Si+2 ayant des niveaux de protection qui peuvent être différents entre eux, soit au plus trois niveaux différents de protection. Si la matrice de poinçonnage Pi+2, i.e. la matrice ajoutée distinctive, contient au moins un zéro alors les deux sorties Si+1 et Si+2 ont des niveaux de protection qui sont différents entre eux. Si la matrice de poinçonnage Pi+1 contient au moins un zéro alors la sortie Si a un niveau de protection qui est différent d'une part du niveau de protection de la sortie Si+1 et d'autre part du niveau de protection de la sortie Si+2.

L'ajout d'une nouvelle structure élémentaire délimitée par un trait discontinu sur la figure 9 permet d'obtenir un niveau supplémentaire de protection qui peut être distinct des autres niveaux de protection en fonction du paramétrage de la matrice de poinçonnage non commune, Pi+2, de la structure ajoutée.

L'architecture en cascade avant-arrière avec reprise du module de poinçonnage précédent permet d'accroitre avec beaucoup de simplicité et de flexibilité l'ordre de poinçonnage (i.e. le nombre de niveaux de poinçonnage). Un niveau de poinçonnage supplémentaire est obtenu par l'ajout d'un seul étage de la structure élémentaire et le paramétrage du poinçonneur suivant la protection considérée. La structure élémentaire montée en cascade avant-arrière permet de simplifier l'adaptation du poinçonnage suivant l'ordre M de la modulation.

Selon un mode de réalisation, le dispositif SB/Tal de télécommunication destiné à communiquer avec un autre dispositif Tal/SB comprend un poinçonneur POIN avec au moins deux structures élémentaires selon un montage en cascade avant-arrière décrit ci-dessus. Chaque structure élémentaire est associée à une étape de poinçonnage du procédé d'émission.

Le procédé 10 d'émission de données mis en œuvre par ce mode de réalisation du dispositif SB/Tal est tel qu'il comprend une première étape de poinçonnage comprenant une 1$^{ère}$ matrice de poinçonnage dont la sortie alimente un démultiplexage ayant une 1$^{ère}$ et une 2e sorties, la 2e sortie alimentant une 2nde matrice de poinçonnage pour définir les au moins deux niveaux de protection différents obtenus respectivement avec la 1$^{ère}$ sortie du démultiplexage et la sortie de la 2nde matrice de poinçonnage. Et le procédé est tel que toute étape de poinçonnage dite étape précédente, donc en particulier la première étape de poinçonnage, est suivie d'une nouvelle étape de poinçonnage dont la 1$^{ère}$ matrice est commune avec la 2$^{nde}$ matrice de l'étape précédente, pour définir un niveau de protection différent supplémentaire obtenu avec la sortie de la 2$^{nde}$ matrice de poinçonnage de la nouvelle étape de poinçonnage.

Ainsi, lorsque le poinçonneur comprend deux structures élémentaires en cascade avant-arrière, le procédé d'émission mis en œuvre comprend deux étapes de poinçonnage. Chaque structure élémentaire additionnelle du poinçonneur ajoute une étape de poinçonnage au procédé mis en œuvre.

Un poinçonneur a quatre sorties donc avec au moins trois structures élémentaires en cascade avant-arrière peut permettre d'attribuer une protection distincte aux données en fonction de la position du symbole sur lequel sont mappées ces données poinçonnées. Cette protection en fonction de la position du symbole s'ajoute à une protection distincte entre des données mappées sur le bit de poids fort et des données mappées sur le bit de poids faible d'un même symbole. En particulier, deux niveaux de protection peuvent être réservés aux données mappées sur un symbole de périphérie de la constellation donc fonction de la position du symbole avec une distinction entre ces deux niveaux selon que les données sont mappées sur un bit de poids fort ou un bit de poids faible de ce symbole.

Ainsi, l'invention permet de différencier conjointement la protection au sein d'un symbole en tenant compte de la position du bit dans le mot de code et suivant la position du symbole dans la constellation.

Pour attribuer une protection distincte aux données poinçonnées en fonction de la position du symbole sur lequel sont mappées ces données, le paramétrage de la structure en cascade avant-arrière du poinçonneur peut tenir compte d'une métrique d'évaluation de la distance du symbole complexe au centre de la constellation.

Selon un mode de réalisation de l'invention, le paramétrage du poinçonneur détermine le nombre de structures élémentaires en cascade avant-arrière pour distinguer des niveaux de protection entre les symboles en fonction de leur position dans la constellation évaluée par la métrique.

Détermination des matrices de poinçonnage

Le codeur COD effectue par exemple un codage canal de type convolutif ou de type LDPC de rendement $R_i$, le code est dit code mère de rendement $R_i$.

En considérant la structure élémentaire du poinçonneur illustrée par la figure 8, le ratio de poinçonnage $R_{pi}$ supérieur ou égal à 1, désigne le rapport entre le nombre de bits à l'entrée du module de poinçonnage Pi et le nombre de bits en sortie de ce module Pi. Ce rapport se déduit de la matrice de poinçonnage Pi qui spécifie le nombre et la position des bits à poinçonner et donc non transmis par le module de poinçonnage Pi. Par convention en vertu du décodage en aval du dépoinçonnage, les bits poinçonnés sont désignés par l'entier '0' dans la matrice Pi et les bits transmis sont désignés par l'entier '1' dans cette matrice Pi. Le ratio de poinçonnage $R_{pi}$ s'écrit :

$$R_{pi} = N_{in,i}/N_{out,i} \geq 1 \qquad (6)$$

où $N_{in,i}$ désigne le nombre de bits à l'entrée du module de poinçonnage Pi et $N_{out,i}$ désigne le nombre de bits à la sortie de ce module Pi. Selon une mise en œuvre simple, $N_{in,i}$ représente le nombre total d'éléments de la matrice de poinçonnage Pi et $N_{out,i}$ représente le nombre d'éléments à '1' dans la matrice de poinçonnage Pi.

Plus généralement, la matrice de poinçonnage Pi comporte un nombre de lignes multiple de l'inverse du rendement $R_i$ du code mère. Le nombre de colonnes est multiple du numérateur du rendement de code désiré $R_{si}$ après poinçonnage tel que :

$$R_{si} = R_i \times N_{in,i}/N_{out,i} \qquad (7)$$

$R_{si}$ est donc le rendement de codage canal sur la branche i, de sortie Si, après poinçonnage par le module de poinçonnage Pi.

La détermination du rendement de codage canal sur la branche i permet ainsi de déterminer au moins une matrice de poinçonnage qui permet d'obtenir le ratio $R_{pi}$.

Le démultiplexage effectué par le démultiplexeur Mi consiste à ajuster le nombre de bits sur chacune des branches de sortie Si et Si+1 compte tenu des matrices de poinçonnage Pi et Pi+1. Cet ajustement se détermine de proche en proche, suivant les contraintes d'optimisation des débits d'entrée et de sortie du poinçonneur.

Selon un mode de réalisation de l'invention, le débit binaire est fixé identique sur chacune des branches en sortie de la structure élémentaire : $D_{Si} = D_{Si+1} = D_b/n_b$, avec $n_b$ le nombre de branches en sortie du poinçonneur, $n_b = 2$ selon l'exemple détaillé ci-après.

Le démultiplexeur Mi répartit les bits sur les branches Fi et Fi+1 en tenant compte du ratio $R_{pi+1}$ de la matrice de poinçonnage Pi+1. Les débits binaires en différents points de la structure élémentaire se calculent alors comme suit :

$$D_{Si} = D_{Si+1} = D_{Fi} = D_{F'i+1} = D_b/2 \qquad (8)$$

$$D_{Fi+1} = D_{F'i+1} \times N_{in,i+1}/N_{out,i+1} = D_{F'i+1} \times R_{pi+1} = R_{pi+1} \times D_b/2 \qquad (9)$$

$$D_{E'i} = D_{Fi+1} + D_{Fi} = \left(1 + R_{pi+1}\right) \times D_b/2$$

Le débit binaire $D_{Ei}$ en sortie du codeur canal s'exprime en fonction du débit binaire en sortie de la structure élémentaire comme suit :

$$D_{Ei} = D_{E'i} \times R_{pi} = R_{pi} \times \left(1 + R_{pi+1}\right) \times D_b/2 \qquad (10)$$

Comme la matrice de poinçonnage Pi poinçonne les bits du flux d'entrée de façon uniforme, le seul changement de son paramétrage permet de modifier le couple des rendements sur les deux sorties. Selon un premier paramétrage, la matrice de poinçonnage Pi peut être formée uniquement de '1' pour ne pas effectuer de poinçonnage sur les bits codés en sortie du codeur canal. Ces bits peuvent par exemple correspondre aux bits d'information issus d'un codeur systématique, bits d'information qui ne sont généralement pas poinçonnés. Selon un autre paramétrage, la matrice de poinçonnage Pi peut être utilisée par exemple pour réduire la redondance associée à certains symboles suivant leur position dans la constellation. Ainsi, un premier paramétrage de la matrice de poinçonnage Pi, par exemple $R_{pi} = 1$, donne un couple de niveaux de protection pour tous les symboles de périphérie. Et un deuxième paramétrage, par exemple $R_{pi} > 1$, donne un autre couple de niveaux de protection pour tous les symboles hormis ceux de périphérie. Ainsi, le module de poinçonnage Pi qui poinçonne uniformément les bits peut permettre un poinçonnage supplémentaire des données mappées sur les symboles les plus proches du centre O de la constellation.

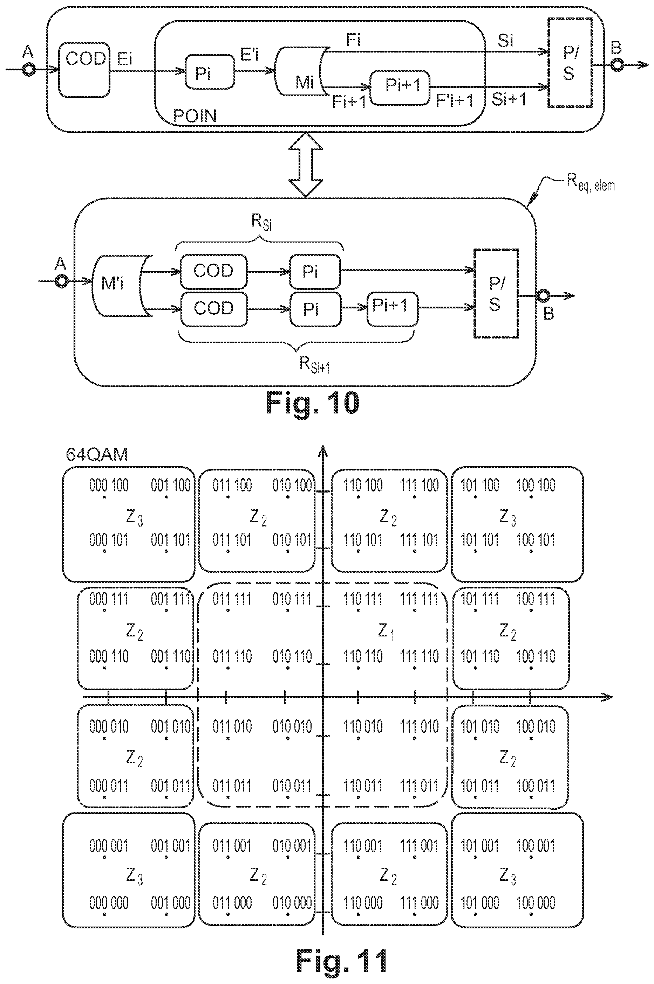

La figure 10 donne un schéma de deux modes de réalisation de l'invention.

Selon le premier mode, le poinçonneur POIN comprend une structure élémentaire telle que déjà décrite en regard de la figure 8. Le poinçonneur poinçonne les données après codage par un codeur COD. Les données de sortie du poinçonneur peuvent être représentées par deux flux correspondant aux deux sorties Si et Si+1 ou peuvent être représentées sous la forme d'un seul flux regroupant les deux sorties.

Selon le deuxième mode qui est équivalent au premier mode d'un point de vue codage canal, les données d'entrée sont d'abord démultiplexées par un démultiplexeur M'i pour distinguer deux sorties. La première sortie du démultiplexeur M'i est codée par un premier codeur canal COD. Les données de sortie du premier codeur canal COD sont poinçonnées par un premier module de poinçonnage de matrice Pi. La deuxième sortie du démultiplexeur M'i est codée par un deuxième codeur canal COD identique au premier codeur canal COD. Les données de sortie du deuxième codeur canal COD sont poinçonnées par un deuxième module de poinçonnage de matrice Pi. Les données poinçonnées par ce deuxième module de poinçonnage de matrice Pi sont de nouveau poinçonnées par un troisième module de poinçonnage de matrice Pi+1.

Ce deuxième mode permet de calculer le rendement de codage canal équivalent $R_{eq,elem}$ de la structure élémentaire de poinçonnage avec codage canal, entre le point d'entrée A et le point de sortie B après une mise en série des deux sorties du poinçonneur.

Le rendement de codage canal équivalent se déduit de l'équation (10) :

$$R_{eq,elem} = R_i \times R_{pi} \times \frac{1+R_{pi+1}}{2} \tag{11}$$

Il peut être défini un ratio de poinçonnage équivalent pour la structure élémentaire :

$$R_{peq,elem} = R_{eq,elem}/R_i = R_{pi} \times \frac{1+R_{pi+1}}{2}$$

L'équivalence des structures des deux modes permet d'ajuster les ratio $R_{pi}$ et $R_{pi+1}$ pour un codeur canal COD donné de rendement $R_i$ afin de générer un rendement de codage canal équivalent cible pour les symboles de la constellation.

Les rendements de codage canal équivalents sur les branches Si et Si+1 sont donnés par :

$$R_{Si} = R_i \times R_{pi} \quad et \quad R_{Si+1} = R_i \times R_{pi} \times R_{pi+1} \tag{12}$$

Les valeurs du couple {$R_{pi}$, $R_{pi+1}$} pour un rendement de codage cible $R_{eq,elem}$ sont ajustées suivant la granularité souhaitée des débits.

L'équivalence des structures des deux modes illustrés sur la Figure 10 illustre la réduction de complexité apportée par la structure élémentaire de poinçonnage multi-niveaux lorsqu'une parallélisation des structures de codage est choisie afin de limiter la vitesse de traitement de codage associée à chaque branche. Un tel choix de parallélisation du codage peut être mis en œuvre pour des systèmes très haut débit, typiquement pour des systèmes opérant en bande millimétrique ou dans la bande des THz. La structure de poinçonnage multi-niveaux proposée permet une réduction de complexité d'une structure de codage canal multi niveaux à l'émission tout en assurant en aval un codage binaire à signal à protection multiple.

Poinçonneur a deux structures élémentaires

Pour le poinçonneur illustré par la figure 9 i.e. à deux structures élémentaires, et dans le cas où les trois sorties Si, Si+1 et Si+2 présentent un même débit binaire, les débits à différents endroits peuvent être exprimés comme suit :

$$D_{Si} = D_{Si+1} = D_{Si+2} = D_{G'i+2} = D_{Gi+1} = D_{Fi} = \frac{D_b}{n_b} \; avec \; n_b = 3 \tag{13}$$

$$D_{Gi+2} = D_{G'i+2} \times \frac{N_{in,i+2}}{N_{out,i+2}} = D_{G'i+2} \times R_{pi+2} = R_{pi+2} \times \frac{D_b}{3}$$

$$D_{F'i+1} = D_{Gi+2} + D_{Gi+1} = \left(1 + R_{pi+2}\right) \times \frac{D_b}{3} \tag{14}$$

$$D_{Fi+1} = D_{F'i+1} \times \frac{N_{in,i+1}}{N_{out,i+1}} = D_{F'i+1} \times R_{pi+1} = R_{pi+1} \times \left(1 + R_{pi+2}\right) \times \frac{D_b}{3} \tag{15}$$

$$D_{E'i} = D_{Fi+1} + D_{Fi} = \left(1 + R_{pi+1} \times \left(1 + R_{pi+2}\right)\right)\frac{D_b}{3}$$

$$D_{Ei} = R_{pi} \times D_{E'i} = R_{pi}\left(1 + R_{pi+1} \times \left(1 + R_{pi+2}\right)\right)\frac{D_b}{3} \tag{16}$$

Les rendements de codage canal équivalents sur chacune des trois branches sont donc donnés par :

$$R_{Si} = R_i \times R_{pi} \; ; \; R_{Si+1} = R_i \times R_{pi} \times R_{pi+1} \; ; \; R_{si+2} = R_i \times R_{pi} \times R_{pi+1} \times R_{pi+2} \tag{17}$$

Le rendement de codage canal équivalent global est donc donné par :

$$R_{eq} = R_i \times R_{pi} \times \frac{\left(1 + R_{pi+1} \times \left(1 + R_{pi+2}\right)\right)}{3} \tag{18}$$

Le ratio de poinçonnage équivalent pour la structure s'exprime sous la forme :

$$R_{peq} = R_{pi} \times \frac{\left(1 + R_{pi+1} \times \left(1 + R_{pi+2}\right)\right)}{3} \tag{19}$$

Poinçonneur à J structures élémentaires

Un poinçonneur qui comprend J structures élémentaires en cascade avant-arrière fournit J+1 sorties. Si le débit binaire est fixé identique à $\frac{D_b}{J+1}$ sur chacune des sorties dites aussi branches alors le débit à l'entrée de chaque démultiplexeur non uniforme se calcule de proche en proche en tenant compte du rapport de poinçonnage de chaque module de poinçonnage. Les rendements de codage canal équivalents sur chaque branche sont donc donnés par :

$$R_{Si} = R_i \times R_{pi} \; ; \; R_{Si+l} = R_i \times \prod_{m=1}^{l} R_{pi} \times R_{pi+m} \quad l > 0 \tag{20}$$

avec

$$R_{pi+l} = \frac{N_{in,i+l}}{N_{out,i+l}} \, , l = \{0, \ldots J+1\}.$$

Et le rendement de codage canal équivalent est donné par :

$$R_{eq} = \frac{1}{J+1} \times \sum_{l=0}^{J} R_{Si+l} = R_i \times R_{pi} \frac{1 + \sum_{l=1}^{J} \prod_{m=1}^{l} R_{pi+m}}{J+1} \tag{21}$$

Le calcul du débit $D_{Ei}$ à l'entrée du poinçonneur peut alors s'écrire sous la forme :

$$D_{Ei} = \frac{R_{eq}}{R_i} \times D_b \tag{22}$$

Le ratio de poinçonnage équivalent du poinçonneur s'exprime alors sous la forme :

$$R_{peq} = \frac{1}{J+1} \times \frac{1}{R_i} \times \sum_{l=0}^{J} R_{Si+l} = R_{pi} \times \frac{1 + \sum_{l=1}^{J} \prod_{m=1}^{l} R_{pi+m}}{J+1} \tag{23}$$

Exemples de paramétrage du poinçonneur lors de mises en œuvre de l'invention

Pour les exemples suivants, les dispositifs de télécommunications considérés sont compatibles d'un standard IEEE 802.1 1ax. Le codeur COD effectue un codage convolutif de rendement ½ et il a une longueur de contrainte L=7. Les MCS (Modulation and Coding Scheme) cibles considérés 16-QAM ¾, 64-QAM ¾. 64-QAM 5/6 sont spécifiés par ce standard.
Selon un premier cas d'usage, le poinçonneur mis en œuvre selon l'invention modifie la protection des bits au sein de chaque symbole ainsi que la protection des symboles les plus éloignés du centre de la constellation tout en gardant inchangé le rendement de codé fixé par le MCS.

Selon un premier exemple, le MCS d'indice 4 est une 16-QAM ¾.

Le MCS est constant pour tous les symboles de la constellation ce qui signifie que le débit utile d'information n'est pas modifié par l'invention et est identique pour tous les points de la constellation. Ceci impose donc de générer plusieurs couples ($R_{p1}$, $R_{p2}$) en fonction de la distance R au centre de la constellation.

Deux niveaux distincts sont considérés suivant la distance d'une part pour les distances R0, R1 et d'autre part pour la distance R2. Un poinçonneur avec une structure élémentaire (deux branches/deux sorties {S1, S2}) et deux paramétrages distincts peut donc convenir puisque deux niveaux de protection sont obtenus pour chacun des deux paramétrages. Les deux sorties du poinçonneur permettent de distinguer entre des données mappées sur le bit de poids fort et des données mappées sur le bit de poids faible d'un même symbole.

Les deux paramétrages correspondent à deux couples de valeurs ($R_{p1}$, $R_{p2}$) respectivement pour les points situés aux distances R0 et R1 et pour ceux situés à la distance R2 du centre de la constellation. La contrainte d'un rendement $R_{MCS}$ inchangé quel que soit le point de la constellation impose un jeu de deux couples de valeurs ($R_{p1}$, $R_{p2}$).

Le rendement du code mère du codeur canal $R_i$ = 1/2 et le MCS permettent d'en déduire d'après l'équation (11) que :

$$R_{eq,elem} = R_{MCS} = \frac{3}{4} = \frac{1}{2} \times R_{p1} \times \frac{1+R_{p2}}{2} \text{ d'où } R_{p1} \times \left(1 + R_{p2}\right) = 3$$

Plusieurs valeurs de $R_{p1}$ et $R_{p2}$ peuvent être sélectionnées suivant la protection choisie en fonction de la distance au centre de la constellation. Les ratios $R_{p1}$ et $R_{p2}$ sont supérieurs ou égaux à un en vertu de l'opération de poinçonnage. Les rendements de codage canal $R_{S1}$ et $R_{S2}$ sur chacune des branches S1 et S2 sont inférieurs ou égaux à un.

Pour les points à la distance R2.

Par exemple si $R_{p1} = \frac{6}{5}$ alors $R_{p2} = \frac{9}{6} = \frac{3}{2}$.

D'après l'équation (12), les rendements de codage canal équivalents sur les branches S1 et S2 sont donnés par :

$$R_{S1} = R_i \times R_{p1} = \frac{1}{2} \times \frac{6}{5} = \frac{3}{5}$$

$$R_{S2} = R_i \times R_{p1} \times R_{p2} = \frac{1}{2} \times \frac{6}{5} \times \frac{3}{2} = \frac{9}{10}$$

La branche S1 est assignée aux bits de poids faible avec un rendement équivalent égal à 3/5 tandis que la branche S2 est assignée aux bits de poids fort avec un rendement 9/10. Le rendement global est bien égal à ¾.

Les matrices de poinçonnage associées sont formées de deux lignes et peuvent comporter trois colonnes. Elles peuvent être sous la forme :

$$P1 = \begin{pmatrix} 1 & 1 & 1 \\ 0 & 1 & 1 \end{pmatrix} \text{ et } P2 = \begin{pmatrix} 1 & 0 & 1 \\ 1 & 1 & 0 \end{pmatrix}$$

Pour les points situés aux distances R0 et R1.

Un second couple ($R_{p1}$, $R_{p2}$) est déterminé en considérant un rendement $R_{S1}$ plus élevé pour les bits de poids faible que pour les points à distance R2 car la région de décision des symboles est identique à celle des bits de poids faible.

Par exemple $R_{S1} = \frac{2}{3} > \frac{3}{5}$ :

Alors $R_{S1} = \frac{2}{3} = R_i \times R_{p1} = \frac{1}{2} \times R_{p1}$ d'où $R_{p1} = \frac{4}{3}$

Et comme $R_{p1} \times (1 + R_{p2})$ = 3 alors $R_{p2} = \frac{5}{4} = \frac{10}{8}$

Les rendements sur chaque branche sont donc :

$$R_{S1} = \frac{2}{3} \text{ et } R_{S2} = R_i \times R_{p1} \times R_{p2} = \frac{1}{2} \times \frac{4}{3} \times \frac{5}{4} = \frac{5}{6}$$

Les matrices de poinçonnage correspondantes peuvent avoir la forme :

$$P1 = \begin{pmatrix} 1 & 1 \\ 0 & 1 \end{pmatrix} \text{ et } P2 = \begin{pmatrix} 1 & 1 & 1 & 0 & 1 \\ 1 & 0 & 1 & 1 & 1 \end{pmatrix}$$

La [Table 5] en Annexe donne un condensé des valeurs pour cet exemple.

Selon un deuxième exemple la modulation est une 64-QAM ¾ et le poinçonnage selon l'invention est mis en œuvre pour uniquement certains symboles, ceux à la distance R2 i.e. les plus éloignés du centre. Le MCS reste constant pour tous les symboles. La [Table 6] en Annexe donne un condensé des valeurs pour cet exemple. Le procédé met en œuvre deux couples de poinçonnage et donc de rendement de codage canal équivalent, un couple pour les données mappées sur les symboles aux distances R0 et R1, un couple pour les données mappées sur les symboles à la distance R2. La table donne deux valeurs (2/3, 5/6) (3/5, 9/10) du couple de rendement de codage canal équivalent pour les données mappées sur les symboles à la distance R2. Cet exemple permet d'illustrer que les mêmes données d'entrée peuvent être poinçonnées différemment, en utilisant les deux couples de poinçonnage (4/3, 10/8) et (6/5, 6/4), tout en obtenant un même rendement de code équivalent, ¾ selon l'exemple. Ces mêmes données poinçonnées différemment permettent d'obtenir une diversité sur les données transmises.

Selon un troisième exemple la modulation est une 64-QAM ¾. En considérant que la modulation 64-QAM est construite avec deux modulations 32-QAM alors trois bits sont associés à chaque symbole d'une constellation 8-QAM. Trois niveaux de protection différents peuvent donc être utilisés pour protéger différemment les données selon sur lequel des trois bits elles sont mappées. La [Table 7] donne un condensé des valeurs pour cet exemple.

Le poinçonneur retenu comporte deux structures élémentaires en cascade qui permet d'obtenir trois sorties avec trois rendements équivalents de codage ($R_{S1}$, $R_{S2}$, $R_{S3}$) et trois ratio de poinçonnage ($R_{p1}$, $R_{p2}$, $R_{p3}$).

Trois zones Z1, Z2, Z3 de symboles sont distinguées comme illustré par la figure 11 en fonction de leur distance au centre de la constellation. Pour protéger ces trois zones, il est déterminé trois triplets différents de rendements équivalents de codage ($R_{S1}$, $R_{S2}$, $R_{S3}$) et de ratio de poinçonnage ($R_{p1}$, $R_{p2}$, $R_{p3}$).

Conformément au premier cas d'usage, le rendement de code fixé par le MCS est conservé inchangé pour tous les points de la constellation quelle que soit leur position.

Le rendement du code mère du codeur canal $R_i$ = 1/2 et le MCS permettent d'en déduire d'après l'équation (11) que :

$$R_{eq} = R_{MCS} = \frac{3}{4}$$

et

$$R_{eq} = \frac{1}{2} \times R_{p1} \times \frac{(1 + R_{p2} + R_{p2} \times R_{p3})}{3}$$

D'où : $R_{p1} \times (1 + R_{p2} + R_{p2} \times R_{p3}) = \frac{9}{2}$

Par exemple si $R_{p1}$ = 1 alors il est possible de choisir $R_{p2}$ = 6/4 et $R_{p3}$ = 14/12.

Les rendements de codage canal équivalents sur chacune des branches sont alors donnés par :

$$R_{S1} = R_i \times R_{p1} = \frac{1}{2}, \ R_{S2} = R_i \times R_{p1} \times R_{p2} = \frac{3}{4} \text{ et } R_{S3} = R_i \times R_{p1} \times R_{p2} \times R_{p3} = \frac{1}{2} \times \frac{6}{4} \times \frac{14}{12} = \frac{7}{8}$$

La branche S3 est assignée aux bits de poids fort, la branche S2 aux bits de poids intermédiaire et la branche S1 aux bits de poids faible.

Le jeu de ratio de poinçonnage (1, 6/4, 14/12) est considéré pour les symboles de la zone Z3.

Le jeu de ratio de poinçonnage (9/8, 4/3, 10/8) est considéré pour les symboles de la zone Z2.

Le jeu de ratio de poinçonnage (4/3, 19/16, 1) est considéré pour les symboles de la zone Z1.

La [Table 7] en Annexe donne un condensé des valeurs pour cet exemple précédent.

Selon un deuxième cas d'usage, le poinçonneur mis en œuvre selon l'invention garde inchangé en moyenne sur tous les symboles de la constellation le rendement $R_{MCS}$ de code fixé par le MCS. Selon ce cas d'usage, le débit binaire utile assigné aux différents symboles de la constellation peut être différent suivant leur distance au centre de la constellation tout en conservant constant le débit moyen binaire à l'échelle des M symboles de la modulation d'ordre M.

Il est considéré pour exemple, une modulation 16-QAM ¾ avec un débit utile plus élevé pour les symboles de la constellation les plus proches, par exemple aux distances R0 et R1 et un débit utile plus faible pour les symboles les plus éloignés, par exemple à la distance R2 tout en conservant inchangé le débit moyen sur les M points de la constellation. Ceci revient à définir deux rendements de codage canal équivalents $R_{eq,1}$ et $R_{eq,2}$ tels que le rendement moyen pondéré par les nombres de points de constellation affectés par ces deux rendements réponde à l'équation suivante :

$$R_{eq} = \frac{N_1 R_{eq,1} + N_2 R_{eq,2}}{N_1 + N_2} = R_{MCS}$$

$$N_1 + N_2 = M$$

$N_1$ est le nombre de points de la constellation ayant le rendement équivalent $R_{eq,1}$ et $N_2$ est le nombre de points de la constellation ayant le rendement équivalent $R_{eq,2}$.

Par exemple, $N_1 = 12$ et $N_2 = 4$. Alors, en supposant $R_{eq,1} > R_{eq,2}$ il faut résoudre l'équation

$$12 \times R_{eq,1} + 4 \times R_{eq,2} = \frac{3}{4} \times 16 = 12$$

Par exemple, $\left(R_{eq,1}, R_{eq,2}\right) = \left(\frac{5}{6}, \frac{1}{2}\right)$ ce qui revient à ne pas poinçonner les bits mappés sur les symboles les plus éloignés de la constellation localisés dans la zone 2 i.e. à la distance R2.

Pour la zone 1, i.e. les symboles aux distances R0 et R1, le rendement est égal à 5/6. Le procédé peut appliquer de façon uniforme le poinçonnage du standard sur l'ensemble des bits mappés sur les symboles de la zone 1. Ou de manière alternative, le procédé peut appliquer un poinçonnage variable au sein de chaque symbole de la zone 1 tel que :

$$R_{eq,1} = \frac{5}{6} = \frac{1}{2} \times R_{p1} \times \frac{1 + R_{p2}}{2} \rightarrow R_{p1} \times \left(1 + R_{p2}\right) = \frac{10}{3}$$

Plusieurs valeurs vérifient l'équation ci-dessus. Par exemple, $\{R_{p1}, R_{p2}\} = \{\frac{3}{2}, \frac{11}{9}\}$

Annexe

[Table 1]

| Indice symbole | Codage binaire sur 4 bits | | | | Codage de Gray sur 4 bits | | | |
|---|---|---|---|---|---|---|---|---|
| | $b_3$ | $b_2$ | $b_1$ | $b_0$ | $G_3$ | $G_2$ | $G_1$ | $G_0$ |
| 0 | 0 | 0 | 0 | 0 | 0 | 0 | 0 | 0 |
| 1 | 0 | 0 | 0 | 1 | 0 | 0 | 0 | 1 |
| 2 | 0 | 0 | 1 | 0 | 0 | 0 | 1 | 1 |
| 3 | 0 | 0 | 1 | 1 | 0 | 0 | 1 | 0 |
| 4 | 0 | 1 | 0 | 0 | 0 | 1 | 1 | 0 |
| 5 | 0 | 1 | 0 | 1 | 0 | 1 | 1 | 1 |
| 6 | 0 | 1 | 1 | 0 | 0 | 1 | 0 | 1 |
| 7 | 0 | 1 | 1 | 1 | 0 | 1 | 0 | 0 |
| 8 | 1 | 0 | 0 | 0 | 1 | 1 | 0 | 0 |
| 9 | 1 | 0 | 0 | 1 | 1 | 1 | 0 | 1 |
| 10 | 1 | 0 | 1 | 0 | 1 | 1 | 1 | 1 |
| … | … | … | … | … | … | … | … | … |
| 14 | 1 | 1 | 1 | 0 | 1 | 0 | 0 | 1 |
| 15 | 1 | 1 | 1 | 1 | 1 | 0 | 0 | 0 |

[Table 2]

| indice symbole | Codage binaire sur 3 bits | | | | Codage de Gray sur 3 bits | | |
|---|---|---|---|---|---|---|---|
| | $b_2$ | $b_1$ | $b_0$ | | $G_2$ | $G_1$ | $G_0$ |
| 0 | 0 | 0 | 0 | | 0 | 0 | 0 |
| 1 | 0 | 0 | 1 | | 0 | 0 | 1 |
| 2 | 0 | 1 | 0 | | 0 | 1 | 1 |
| 3 | 0 | 1 | 1 | | 0 | 1 | 0 |
| 4 | 1 | 0 | 0 | | 1 | 1 | 0 |
| 5 | 1 | 0 | 1 | | 1 | 1 | 1 |
| 6 | 1 | 1 | 0 | | 1 | 0 | 1 |
| 7 | 1 | 1 | 1 | | 1 | 0 | 0 |

[Table 3]

| Indice symbole | Symbole 16-aire pour une modulation 16 QAM | | | | |
|---|---|---|---|---|---|
| | $b_3 b_2$ | Voie I | $b_1 b_0$ | Voie Q |
| 0 | 00 | -3 | 00 | -3 |
| 1 | 01 | -1 | 01 | -1 |
| 2 | 11 | 1 | 11 | 1 |

(suite)

| Indice symbole | Symbole 16-aire pour une modulation 16 QAM | | | |
|---|---|---|---|---|
| | $b_3b_2$ | Voie I | $b_1b_0$ | Voie Q |
| 3 | 10 | 3 | 10 | 3 |

[Table 4]

| Indice symbole | Symbole 64-aire pour une modulation 64 QAM | | | |
|---|---|---|---|---|
| | $b_5b_4b_3$ | Voie I | $b_2b_1b_0$ | Voie Q |
| 0 | 000 | -7 | 000 | -7 |
| 1 | 001 | -5 | 001 | -5 |
| 2 | 011 | -3 | 011 | -3 |
| 3 | 010 | -1 | 010 | -1 |
| 4 | 110 | 1 | 110 | 1 |
| 5 | 111 | 3 | 111 | 3 |
| 6 | 101 | 5 | 101 | 5 |
| 7 | 100 | 7 | 100 | 7 |

[Table 5]

| **Modulation** | | 16-QAM 3/4 | | |
|---|---|---|---|---|
| **Mapping des bits** | $(b_3,b_1)\to R_{s2}$ | | $(b_2,b_0)\to R_{s1}$ | |
| **Distance** | $(R_{p1},R_{p2})$ | **(P1, P2)** **Pi (nb lignes, nb colonnes)** | $(R_{S1}, R_{S2})$ | $R_{eq}$ |
| $R1 = \sqrt{10}\ a$ <br> $R0 = \sqrt{2}\ a$ | $(\frac{4}{3}, \frac{10}{8})$ | $P1 = (2,2)$ <br><br> 1 élément poinçonné <br><br> $P2 = (2,5)$ <br> 2 éléments poinçonnés | $(\frac{2}{3}, \frac{5}{6})$ | 3/4 |
| $R2 = 3\sqrt{2}\ a$ | $(\frac{6}{5}, \frac{6}{4})$ | $P1 = (2,3)$ <br><br> 1 élément poinçonné <br> $P2 = (2,3)$ <br> 2 éléments poinçonnés | $(\frac{3}{5}, \frac{9}{10})$ | 3/4 |

[Table 6]

| Modulation | | 16-QAM 3/4 | | |
|---|---|---|---|---|
| Mapping des bits | $(b_3,b_1)\to R_{s2}$ | | $(b_2,b_0)\to R_{s1}$ | |
| Distance | $(R_{p1},R_{p2})$ | **(P1, P2)** **Pi**(nb lignes, nb colonnes) | $(R_{S1}, R_{S2})$ | $R_{eq}$ |
| $R1 = \sqrt{10}\ a$ <br> $R0 = \sqrt{2}\ a$ | $\{\frac{6}{4}, 1\}$ | **P1**Matrice de poinçonnage du standard (2,3) <br><br> **P2** formée de 1 (1,1) | $\{\frac{3}{4}, \frac{3}{4}\}$ | 3/4 |

(suite)

| $R2 = 3\sqrt{2}\,a$ | $\{\frac{4}{3}, \frac{10}{8}\}$ | $P1 = (2,2)$<br><br>1 élément poinçonné<br>$P2 = (2,5)$<br>2 éléments poinçonnés | $\{\frac{2}{3}, \frac{5}{6}\}$ | 3/4 |
|---|---|---|---|---|
| $R2 = 3\sqrt{2}\,a$ | $\{\frac{6}{5}, \frac{6}{4}\}$ | $P1 = (2,3)$<br><br>1 élément poinçonné<br>$P2 = (2,3)$<br>2 éléments poinçonnés | $\{\frac{3}{5}, \frac{9}{10}\}$ | 3/4 |

[Table 7]

| 64-QAM 3/4 | | | $(b_5,b_2) \rightarrow R_{S3}$<br>$(b_4,b_1) \rightarrow R_{S2}$<br>$(b_3,b_0) \rightarrow R_{S1}$ |
|---|---|---|---|
| Distance | $(R_{p1}, R_{p2}, R_{p3})$ | $(P1, P2, P3)$<br>$Pi$ (nb lignes, nb colonnes) | $(R_{S1}, R_{S2}, R_{S3})$ |
| Zone 3 | $(1, \frac{6}{4}, \frac{14}{12})$ | $P1 = (2,1)$<br>0 élément poinçonné<br>$P2 = (2,3)$<br>2 éléments poinçonnés avec la matrice du standard<br>$P3 = (2,7)$<br>2 éléments poinçonnés avec une matrice à définir | $\{\frac{1}{2}, \frac{3}{4}, \frac{7}{8}\}$ |
| Zone 2 | $(\frac{9}{8}, \frac{4}{3}, \frac{10}{8})$ | $P1 = (2,9)$<br>2 éléments poinçonnés<br>P2 et P3 peuvent être les matrices données dans l'exemple 1 | $(\frac{9}{16}, \frac{3}{4}, \frac{15}{16})$ |
| Zone 1 | $(\frac{4}{3}, \frac{19}{16}, 1)$ | | $(\frac{2}{3}, \frac{19}{24}, \frac{19}{24})$ |

**Revendications**

1. Procédé (10) d'émission de données mis en œuvre par un premier équipement de (SB/Tal) télécommunication à destination d'un deuxième équipement (Tal/SB) de télécommunication, comprenant :

   - codage (11) de données d'entrée pour ajouter une redondance au moyen d'un codeur,
   - poinçonnage (12) des données après codage,
   - émission (14) des données après poinçonnage,

   et tel que le poinçonnage est selon au moins deux niveaux de protection différents et tel qu'il comprend au moins une étape de poinçonnage comprenant une 1ère matrice de poinçonnage dont la sortie alimente un démultiplexage ayant une 1ère et une 2e sorties, **caractérisé en ce que** la 2e sortie alimente une 2nde matrice de poinçonnage pour définir les au moins deux niveaux de protection différents obtenus respectivement avec la 1ère sortie du démultiplexage et la sortie de la 2nde matrice de poinçonnage.

2. Procédé (10) d'émission de données selon la revendication 1, tel que toute étape de poinçonnage dite étape précédente est suivie d'une nouvelle étape de poinçonnage dont la 1ère matrice est commune avec la 2nde matrice de l'étape précédente, pour définir un niveau de protection différent supplémentaire obtenu avec la sortie de la 2nde matrice de poinçonnage de la nouvelle étape de poinçonnage.

3. Procédé (1) d'émission de données selon l'une des revendications 1 et 2, tel que, un ratio de poinçonnage étant associé à chaque matrice de poinçonnage, ces ratios sont déterminés pour un débit binaire identique sur chacune des sorties des 2<sup>nde</sup> matrices de poinçonnage des étapes de poinçonnage, pour un ordre de la modulation et pour un rendement du codage déterminés.

4. Procédé (1) d'émission de données selon l'une des revendications 1 à 3, tel que, un ratio de poinçonnage étant associé à chaque matrice de poinçonnage, un changement de niveaux de protection des données est obtenu en modifiant le ratio d'au moins une des matrices de poinçonnage.

5. Procédé (10) d'émission de données selon l'une des revendications 1 à 4, comprenant en outre :

   - mappage (13) des données après poinçonnage sur un symbole parmi M symboles d'une constellation d'ordre q, $M=2^q$ q>=2, chaque symbole de la constellation comprenant au moins deux bits de poids différents parmi q bits, le procédé étant tel que, pour au moins un des M symboles, les deux niveaux de protection différents correspondent à un poinçonnage différent des données en fonction du poids des bits dans le symbole sur lesquels sont mappées ces données, et tel que l'émission (14) des données à destination du deuxième équipement (RE) intervient après mappage.

6. Procédé (10) d'émission de données selon la revendication précédente, tel que chaque symbole de la constellation comprend au moins un bit de poids fort et un bit de poids faible et tel que le poinçonnage (12) des données est différent entre des données mappées sur le bit de poids fort et des données mappées sur le bit de poids faible d'un même symbole.

7. Procédé (1) d'émission de données selon l'une des revendications 5 à 6, tel que la différence de poinçonnage entre des données mappées sur un même symbole intervient pour tous les symboles de la constellation.

8. Procédé (1) d'émission de données selon l'une des revendications 5 à 6, tel que la différence de poinçonnage entre des données mappées sur un même symbole intervient uniquement pour certains des symboles de la constellation.

9. Procédé (10) d'émission de données selon l'une des revendications 5 à 8, tel que le poinçonnage (12) des données est en outre fonction de la position du symbole dans la constellation sur lequel sont mappées ces données après poinçonnage.

10. Procédé (10) d'émission de données selon la revendication précédente, tel que la position du symbole est évaluée par le calcul d'une métrique d'évaluation de la distance du symbole au centre de la constellation.

11. Procédé (20) de communication entre un premier équipement (SB/Tal) et un deuxième équipement (Tal/SB) de télécommunication avec réception (21) d'un signal de données par le deuxième équipement (Tal/SB), les données étant mappées avant émission sur des symboles d'une constellation d'ordre M, $M=2^q$ q>=2, chaque symbole de la constellation comprenant au moins deux bits de poids différents, ledit procédé comprenant :

   - démodulation (22) des symboles avec démappage des données,
   - dé-poinçonnage (23) des données après démappage des données, le poinçonnage des données à l'émission étant différent en fonction du poids des bits dans un symbole sur lesquels sont mappées les données,
   - décodage (24) des données après dé-poinçonnage.

12. Procédé (20) de communication selon la revendication précédente, tel que le dé-poinçonnage (23) des données tient compte d'un poinçonnage à l'émission fonction de la position du symbole dans la constellation sur lequel sont mappées ces données.

13. Equipement (SB/Tal) de télécommunication destiné à communiquer avec un deuxième équipement (Tal/SB), comprenant :

   - un codeur (COD) pour coder des données d'entrée,
   - un poinçonneur (POIN) pour poinçonner les données selon au moins deux niveaux de protection après codage, le poinçonneur comprenant :
   - une structure élémentaire comprenant une 1<sup>ère</sup> matrice de poinçonnage dont la sortie alimente un démultiplexage ayant une 1<sup>ère</sup> et une 2<sup>e</sup> sorties,

**caractérisé en ce que** la 2$^e$ sortie alimente une 2$^{nde}$ matrice de poinçonnage pour définir les au moins deux niveaux de protection différents obtenus respectivement avec la 1$^{ère}$ sortie du démultiplexage et la sortie de la 2$^{nde}$ matrice de poinçonnage.

14. Equipement (SB/Tal) de télécommunication selon la revendication précédente, le poinçonneur étant tel que toute structure élémentaire dite structure précédente est suivie d'une nouvelle structure élémentaire dont la 1$^{ère}$ matrice est commune avec la 2$^{nde}$ matrice de la structure élémentaire précédente, pour définir un niveau de protection différent supplémentaire obtenu avec la sortie de la 2$^{nde}$ matrice de poinçonnage de la nouvelle structure élémentaire.

15. Equipement (SB/Tal) de télécommunication selon l'une des revendications 13 et 14, comprenant en outre :

- un modulateur (MAP) pour mapper les données après poinçonnage sur un symbole parmi M symboles d'une constellation d'ordre M, M=2$^q$ q>=2, chaque symbole de la constellation comprenant au moins deux bits de poids différents,
le poinçonneur (POIN) étant tel que le poinçonnage des données est différent en fonction du poids des bits dans un symbole sur lesquels sont mappées les données.

## Patentansprüche

1. Verfahren (10) zum Senden von Daten, durchgeführt von einer ersten Telekommunikationsausrüstung (SB/Tal), an eine zweite Telekommunikationsausrüstung (Tal/SB), das enthält:

- Codieren (11) von Eingangsdaten, um mittels eines Codierers eine Redundanz hinzuzufügen,
- Punktieren (12) der Daten nach Codierung,
- Senden (14) der Daten nach Punktierung,
und derart, dass die Punktierung gemäß mindestens zwei unterschiedlichen Schutzniveaus eintritt, und derart, dass es mindestens einen Punktierungsschritt enthält, der eine erste Punktierungsmatrix enthält, deren Ausgang eine Demultiplexierung speist, die einen ersten und einen zweiten Ausgang hat,
**dadurch gekennzeichnet, dass** der zweite Ausgang eine zweite Punktierungsmatrix speist, um die mindestens zwei unterschiedlichen Schutzniveaus zu definieren, die mit dem ersten Ausgang der Demultiplexierung bzw. dem Ausgang der zweiten Punktierungsmatrix erhalten werden.

2. Datensendeverfahren (10) nach Anspruch 1, derart, dass auf jeden vorhergehender Schritt genannten Punktierungsschritt ein neuer Punktierungsschritt folgt, dessen erste Matrix mit der zweiten Matrix des vorhergehenden Schritts gemeinsam ist, um ein zusätzliches unterschiedliches Schutzniveau zu definieren, das mit dem Ausgang der zweiten Punktierungsmatrix des neuen Punktierungsschritts erhalten wird.

3. Datensendeverfahren (1) nach einem der Ansprüche 1 und 2, derart, dass, wenn jeder Punktierungsmatrix ein Punktierungsverhältnis zugeordnet ist, diese Verhältnisse für eine gleiche Bitrate auf jedem der Ausgänge der zweiten Punktierungsmatrizen der Punktierungsschritte bestimmt werden, für eine bestimmte Ordnung der Modulation und für einen bestimmten Wirkungsgrad der Codierung.

4. Datensendeverfahren (1) nach einem der Ansprüche 1 bis 3, derart, dass, wenn jeder Punktierungsmatrix ein Punktierungsverhältnis zugeordnet ist, eine Änderung von Schutzniveaus der Daten erhalten wird, indem das Verhältnis mindestens einer der Punktierungsmatrizen verändert wird.

5. Datensendeverfahren (10) nach einem der Ansprüche 1 bis 4, das außerdem enthält:

- Mapping (13) der Daten nach Punktierung auf einem Symbol unter M Symbolen einer Konstellation der Ordnung q, M=2$^q$ q>=2, wobei jedes Symbol der Konstellation mindestens zwei Bits unterschiedlichen Gewichts unter q Bits enthält,
wobei das Verfahren so ist, dass für mindestens eins der M Symbole die zwei unterschiedlichen Schutzniveaus einer unterschiedlichen Punktierung der Daten entsprechen, abhängig vom Gewicht der Bits in dem Symbol, auf das diese Daten mappiert sind,
und so ist, dass das Senden (14) der Daten an die zweite Ausrüstung (RE) nach Mapping eintritt.

6. Datensendeverfahren (10) nach dem vorhergehenden Anspruch, derart, dass jedes Symbol der Konstellation mindestens ein höchstwertiges Bit und ein niedrigstwertiges Bit enthält, und derart, dass die Punktierung (12) zwischen auf das höchstwertige Bit mappierten Daten und auf das niedrigstwertige Bit mappierten Daten eines gleichen Symbols unterschiedlich ist.

7. Datensendeverfahren (1) nach einem der Ansprüche 5 bis 6, derart, dass der Punktierungsunterschied zwischen auf ein gleiches Symbol mappierten Daten für alle Symbole der Konstellation eintritt.

8. Datensendeverfahren (1) nach einem der Ansprüche 5 bis 6, derart, dass der Punktierungsunterschied zwischen auf ein gleiches Symbol mappierten Daten nur für bestimmte der Symbole der Konstellation eintritt.

9. Datensendeverfahren (10) nach einem der Ansprüche 5 bis 8, derart, dass die Punktierung (12) der Daten außerdem von der Position des Symbols in der Konstellation abhängt, auf das diese Daten nach Punktierung mappiert werden.

10. Datensendeverfahren (10) nach dem vorhergehenden Anspruch, derart, dass die Position des Symbols durch die Berechnung einer Einschätzungsmetrik des Abstands des Symbols zur Mitte der Konstellation eingeschätzt wird.

11. Kommunikationsverfahren (20) zwischen einer ersten (SB/Tal) und einer zweiten Telekommunikationsausrüstung (Tal/SB) mit Empfang (21) eines Datensignals von der zweiten Ausrüstung (Tal/SB), wobei die Daten vor dem Senden auf Symbole einer Konstellation der Ordnung M, $M=2^q$ $q>=2$ mappiert werden, wobei jedes Symbol der Konstellation mindestens zwei Bits unterschiedlichen Gewichts enthält, wobei das Verfahren enthält:

    - Demodulation (22) der Symbole mit Demapping der Daten,
    - Depunktierung (23) der Daten nach Demapping der Daten, wobei die Punktierung der Daten beim Senden abhängig vom Gewicht der Bits in einem Symbol, auf das die Daten mappiert sind, unterschiedlich ist,
    - Decodierung (24) der Daten nach Depunktierung.

12. Kommunikationsverfahren (20) nach dem vorhergehenden Anspruch, derart, dass die Depunktierung (23) der Daten eine Punktierung beim Senden abhängig von der Position des Symbols in der Konstellation, auf das diese Daten mappiert sind, berücksichtigt.

13. Telekommunikationsausrüstung (SB/Tal), dazu bestimmt, mit einer zweiten Ausrüstung (Tal/SB) zu kommunizieren, die enthält:

    - einen Codierer (COD), um Eingangsdaten zu codieren,
    - einen Punktierer (POIN), um die Daten gemäß mindestens zwei Schutzniveaus nach Codierung zu punktieren, wobei der Punktierer enthält:
    - eine elementare Struktur, die eine erste Punktierungsmatrix enthält, deren Ausgang eine Demultiplexierung speist, die einen ersten und einen zweiten Ausgang hat,

    **dadurch gekennzeichnet, dass** der zweite Ausgang eine zweite Punktierungsmatrix speist, um die mindestens zwei unterschiedlichen Schutzniveaus zu definieren, die mit dem ersten Ausgang der Demultiplexierung bzw. dem Ausgang der zweiten Punktierungsmatrix erhalten werden.

14. Telekommunikationsausrüstung (SB/Tal) nach dem vorhergehenden Anspruch, wobei der Punktierer derart ist, dass auf jede vorhergehende Struktur genannte elementare Struktur eine neue elementare Struktur folgt, deren erste Matrix mit der zweiten Matrix der vorhergehenden elementaren Struktur gemeinsam ist, um ein zusätzliches unterschiedliches Schutzniveau zu definieren, das mit dem Ausgang der zweiten Punktierungsmatrix der neuen elementaren Struktur erhalten wird.

15. Telekommunikationsausrüstung (SB/Tal) nach einem der Ansprüche 13 und 14, die außerdem enthält:

    - einen Modulator (MAP), um die Daten nach Punktierung auf ein Symbol unter M Symbolen einer Konstellation der Ordnung M, $M=2^q$ $q>=2$ zu mappieren, wobei jedes Symbol der Konstellation mindestens zwei Bits unterschiedlichen Gewichts enthält,
    wobei der Punktierer (POIN) derart ist, dass die Punktierung der Daten abhängig vom Gewicht der Bits in einem Symbol, auf das die Daten mappiert sind, unterschiedlich ist.

**Claims**

1. Method (10), implemented by a first telecommunications equipment (SB/Tal), for transmitting data to a second telecommunications equipment (Tal/SB), comprising:

   - coding (11) input data to add redundancy by way of an encoder,
   - puncturing (12) the data after coding,
   - transmitting (14) the data after puncturing,
   and such that the puncturing is in accordance with at least two different levels of protection and such that it comprises at least one puncturing step comprising a first puncturing matrix the output of which is supplied to a demultiplexing stage having a first and a second output,
   **characterized in that** the second output is supplied to a second puncturing matrix so as to define the at least two different levels of protection obtained with the first output of the demultiplexing stage and the output of the second puncturing matrix, respectively.

2. Data transmission method (10) according to Claim 1, such that any puncturing step, referred to as previous step, is followed by a new puncturing step whose first matrix is common with the second matrix of the previous step, so as to define an additional different level of protection that is obtained with the output of the second puncturing matrix from the new puncturing step.

3. Data transmission method (1) according to either of Claims 1 and 2, such that, with a puncturing ratio being associated with each puncturing matrix, these ratios are determined for an identical bit rate on each of the outputs of the second puncturing matrices of the puncturing steps, for a determined order of the modulation and for a determined coding rate.

4. Data transmission method (1) according to one of Claims 1 to 3, such that, with a puncturing ratio being associated with each puncturing matrix, levels of protection of the data are changed by modifying the ratio of at least one of the puncturing matrices.

5. Data transmission method (10) according to one of Claims 1 to 4, furthermore comprising:

   - mapping (13) of the data after puncturing onto a symbol from among M symbols of a constellation of order q, $M=2^q$ $q>=2$, each symbol of the constellation comprising at least two bits of different weight from among q bits, the method being such that, for at least one of the M symbols, the two different levels of protection correspond to a different puncturing of the data depending on the weight of the bits in the symbol, onto which bits these data are mapped,
   and such that the transmission (14) of the data to the second equipment (RE) takes place after mapping.

6. Data transmission method (10) according to the preceding claim, such that each symbol of the constellation comprises at least one most significant bit and one least significant bit and such that the puncturing (12) of the data is different between data mapped onto the most significant bit and data mapped onto the least significant bit of one and the same symbol.

7. Data transmission method (1) according to one of Claims 5 to 6, such that the puncturing difference between data mapped onto one and the same symbol applies for all of the symbols of the constellation.

8. Data transmission method (1) according to one of Claims 5 to 6, such that the puncturing difference between data mapped onto one and the same symbol applies only for some of the symbols of the constellation.

9. Data transmission method (10) according to one of Claims 5 to 8, such that the puncturing (12) of the data is also dependent on the position of the symbol in the constellation onto which these data are mapped after puncturing.

10. Data transmission method (10) according to the preceding claim, such that the position of the symbol is evaluated by computing a metric for evaluating the distance from the symbol to the center of the constellation.

11. Method (20) for communication between a first equipment (SB/Tal) and a second telecommunications equipment (Tal/SB) with reception (21) of a data signal by the second equipment (Tal/SB), the data being mapped before transmission onto symbols of a constellation of order M, $M=2^q$ $q>=2$, each symbol of the constellation comprising at least two bits of different weight, said method comprising:

- demodulating (22) the symbols with demapping of the data,
- depuncturing (23) the data after demapping of the data, the puncturing of the data at transmission being different depending on the weight of the bits in a symbol, onto which bits the data are mapped,
- decoding (24) the data after depuncturing.

**12.** Communication method (20) according to the preceding claim, such that the depuncturing (23) of the data takes into account a puncturing at transmission dependent on the position of the symbol in the constellation onto which these data are mapped.

**13.** Telecommunications equipment (SB/Tal) intended to communicate with a second equipment (Tal/SB), comprising:

- an encoder (COD) for coding input data,
- a puncturer (POIN) for puncturing the data in accordance with at least two levels of protection after coding, the puncturer comprising:
- an elementary structure comprising a first puncturing matrix the output of which is supplied to a demultiplexing stage having a first and a second output, **characterized in that** the second output is supplied to a second puncturing matrix so as to define the at least two different levels of protection obtained with the first output of the demultiplexing stage and the output of the second puncturing matrix, respectively.

**14.** Telecommunications equipment (SB/Tal) according to the preceding claim, the puncturer being such that any elementary structure, referred to as previous structure, is followed by a new elementary structure whose first matrix is common with the second matrix of the previous elementary structure, so as to define an additional different level of protection that is obtained with the output of the second puncturing matrix from the new elementary structure.

**15.** Telecommunications equipment (SB/Tal) according to either of Claims 13 and 14, further comprising:

- a modulator (MAP) for mapping the data after puncturing onto a symbol from among M symbols of a constellation of order M, $M=2^q$ q>=2, each symbol of the constellation comprising at least two bits of different weight, the puncturer (POIN) being such that the puncturing of the data is different depending on the weight of the bits in a symbol, onto which bits the data are mapped.

EP 4 331 152 B1

Fig. 1

Fig. 2

Fig. 3

Fig. 4

Fig. 5

Fig. 6

**Fig. 7**

**Fig. 8**

**Fig. 9**

**Fig. 10**

**Fig. 11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017244588 A1
- US 2008010582 A1
- US 2005172202 A1
- US 2003145273 A1